# EUROPEAN PATENT SPECIFICATION

(11) **EP 0 814 381 B1**
(45) Date of publication and mention of the grant of the patent: **19.09.2001**
(21) Application number: 97110034.2
(22) Date of filing: 19.06.1997
(51) Int. Cl.: G03F 7/004, G03F 7/039

(54) **Positive image forming composition**
Positiv arbeitende, bilderzeugende Zusammensetzung
Composition formant des images de type positif

(30) Priority: 20.06.1996 JP 16027696; 19.07.1996 JP 19093996
(43) Date of publication of application: 29.12.1997
(73) Proprietor: FUJI PHOTO FILM CO., LTD., Kanagawa-ken (JP)
(72) Inventor: Kawamura, Koichi, Yoshida-cho, Haibara-gun, Shizuoka (JP); Uenishi, Kazuya, Yoshida-cho, Haibara-gun, Shizuoka (JP)
(74) Representative: Barz, Peter, Dr.

(56) References cited:
- DE-A- 4 242 050
- DE-A- 4 242 051
- DATABASE WPI Section Ch, Week 8924 Derwent Publications Ltd., London, GB; Class A89, AN 89-175478 XP002042198 & JP 01 114 861 A (FUJI PHOTO FILM CO LTD) , 8 May 1989

## Description

The present invention relates to a positive image forming composition used in the manufacturing process of a lithographic printing plate or a semiconductor device such as IC, in the production of a circuit substrate for liquid crystal, a thermal head or the like, and in other photofabrication processes.

The present invention relates to a photosensitive composition which can be used for a lithographic plate and, more particularly, to a lithographic plate material which makes development-processing unnecessary and has suitability for direct recording of digital signals from a computer.

As positive image forming compositions or positive working lithographic materials, compositions comprising alkali-soluble resins and naphthoquinonediazide compounds as photosensitive material have generally been used.

In a positive photoresist of the foregoing type which is constituted basically of a novolak resin and a quinonediazide compound, the novolak resin acts so as to provide high resistance to plasma etching and the naphthoquinonediazide compound can reduce the dissolution speed of an alkali-soluble novolak resin and functions as a dissolution inhibitor. And, the naphthoquinonediazide has a characteristic of generating a carboxylic acid upon irradiation with light to lose the ability to inhibit dissolution, thereby heightening the solubility of a novolak resin in alkali. Usually, such a material forms a positive image by undergoing the development with an alkali after imagewise exposure.

From the aforementioned points of view, a large number of positive photoresist compositions which each comprise a novolak resin and a naphthoquinonediazide type photosensitive material have hitherto been developed and put to practical use. In the micro-lithography for the lines having a width of the order of 0.8-2 µm, those compositions have accomplished satisfactory results.

On the other hand, the integration degree of an integrated circuit has become higher and higher in recent years, so that the micro-lithography for superfine patterns having a line width of half micron or below has come to be required in the production of semiconductor substrates for VLSI and the like. In order to achieve the resolution required therein, the wavelengths used in an exposure apparatus for photolithography were getting shorter, and nowadays the utilization of far ultraviolet light and excimer laser beams (XeCl, KrF, ArF) is being examined.

In a case where a conventional resist comprising a novolak resin and a naphthoquinonediazide compound is used for forming patterns by the lithography using far ultraviolet light or an excimer laser beam, it is difficult for the light to reach the lower part of the resist because a novolak resin and naphthoquinonediazide have strong absorption in the far ultraviolet region, so that such a resist has low sensitivity and can merely provide a pattern profile having a tapered shape.

As a means for solving the aforementioned problems, the chemically amplified resist compositions described, e.g., in U.S. Patent 4,491,628 and European Patent 0,249,139 can be used. The chemically amplified positive resist compositions refer to the pattern forming materials of the type which generate acids in the irradiated area upon exposure to radiation, such as far ultraviolet light, to cause a reaction utilizing these acids as catalyst, thereby making a difference of solubility in a developer between the areas irradiated and unirradiated with active radiation. By virtue of this solubility difference, a pattern can be formed on a substrate coated with a material of the foregoing type.

As examples of a chemically amplified resist composition, mention may be made of the combination of a compound capable of generating an acid by photolysis (which is called a photoacid generator, hereinafter) with acetal or an O, N-acetal compound (JP-A-48-89003, wherein the term "JP-A" means an unexamined published Japanese patent application"), the combination of a photoacid generator with an orthoester or amidoacetal compound (JP-A-51-120714), the combination of a photoacid generator with a N,N-disubstituted sulfonamide or a polymer having pendant N,N-disubstituted sulfonamide groups (DE-A-4242 050 and DE-A-4242 051), the combination of a photoacid generator with a polymer containing acetal or ketal groups in its main chain (JP-A-53-133429), the combination of a photoacid generator with an enol ether compound (JP-A-55-129936), the combination of a photoacid generator with a polymer containing orthoester groups in its main chain (JP-A-56-17345), the combination of a photoacid generator with a tertiary alkyl ester compound (JP-A-60-3625), the combination of a photoacid generator with a silyl ester compound (JP-A-60-10247) and the combinations of photoacid generators with silyl ether compounds (JP-A-60-37549 and JP-A-60-121446). Those combinations have a quantum yield greater than 1 in principle, so that they exhibit high sensitivity.

As examples of a similar system to the above, which is stable upon storage at room temperature but decomposes by heating in the presence of an acid to acquire solubility in an alkali, mention may be made of the systems described, e.g., in JP-A-59-45439, JP-A-60-3625, JP-A-62-229242, JP-A-63-27829, JP-A-63-36240, JP-A-63-250642, Polym. Eng. Sce., vol. 23, p. 1012 (1983); ACS. Sym., vol. 242, p. 11 (1984); Semiconductor World, the November issue, p. 91 (1987); Macromolecules, vol. 21, p. 1475 (1988); and SPIE, vol. 920, p. 42 (1988); wherein compounds capable of generating acids by exposure to light are combined with tertiary or secondary alkyl (e.g., t-butyl, 2-cyclohexyl) esters or carbonate compounds. Such systems also have high sensitivity, and their absorption in Deep-UV region is weak, compared with a naphthoquinonediazide/novolak resin system. Thus, the use of those systems can also be effective in shortening the wavelengths of a light source.

Those positive resists of chemical amplification type form resist patterns by undergoing development after a heat treatment in the presence of acids generated from photoacid generators by exposure to light. However, those resists have a problem that, in proportion as the standing period from the exposure till the heat treatment (PEB treatment) becomes longer, changes are produced in not only the sensitivity but also the profile and the line width of a resist pattern obtained after development since the generated acid diffuses farther and the deactivation of the acid by basic impurities in the atmosphere proceeds at the resist surface.

In general, the image forming materials as described above, which include positive working lithographic materials constituted basically of a novolak resin and a quinonediazide compound, form images by undergoing the development with an alkali after exposure. However, the development step consumes plenty of time and labor, and what is worse, it is undesirable for workers' safety and environmental preservation because it uses a developer of high alkalinity (generally pH 13).

As a means to solve such a problem, the positive working lithographic materials using polyethylene oxide-resol resin associates are disclosed in U.S. Patents 3,231,377 and 3,231,381. In addition, the positive working lithographic materials using photosensitive polyimides are disclosed in U.S. Patents 3,694,208 and 3,533,798. Further, the positive working photosensitive compositions comprising a photoinitiator capable of generating an acid by exposure and a polymer having alkoxyalkyl esters as side chains are disclosed in U.S. Patent 5,314,785 and European Patent 0,600,615.

Although the printing plates using those positive working photosensitive compositions can certainly produce images without alkali development or by being treated with neutral water alone, they are apt to give rise to scumming during the practical printing operation. Therefore, it is required to make further improvements in them. More specifically, for the reduction of scumming, it is required to enlarge a difference between the hydrophilicity (ink repellency) and the lipophilicity (ink receptivity), especially to heighten the hydrophilicity.

In the field of lithography, on the other hand, there has recently been enhanced interest in lithographic materials which enable the so-called direct platemaking, or the direct recording of digital signals from a computer on a printing plate utilizing laser beams in the visible region or the infrared region device, instead of the systems using conventional light sources (for ultraviolet light).

The photopolymers sensitive to near infrared rays are disclosed in European Patent 0,444,786, JP-A-63-208036 and JP-A-63-274592. Further, European Patent 0,652,483 discloses the positive image forming material which has sensitivities to infrared laser beams and requires no developer.

However, those printing plates have a defect that, although their sensitivities to infrared laser are sufficient, they generate scum in non-image areas upon long-term storage, particularly under a condition of high temperature and high humidity.

As mentioned above, the conventional positive image forming photosensitive materials of the type which require no developer have a problem of being apt to generate scum, particularly upon long-term storage.

Therefore, one object of the present invention is to provide a positive image forming composition suitable for a photoresist composition which is reduced in the resist pattern change depending on the standing period from the exposure till the heat treatment.

Another object of the present invention is to provide a positive image forming composition useful for the production of an offset printing plate which has high sensitivities to from rays in the UV region to those in the infrared region and no scumming in the non-image area.

A further object of the present invention is to provide a positive image forming composition containing an acid cleavable compound which can be produced with ease and at a low price.

A still another object of the present invention is to provide a lithographic printing plate which can afford stain-free printed matters even when it undergoes no development after exposure.

A still further object of the present invention is to provide a printing plate which has high sensitivity to light of wavelengths longer than 350 nm, especially to visible and infrared laser beams, excellent stability upon storage and no scum in the non-image area.

As a result of our intensive studies, it has been found that, when the substituent on the N atom of an N-sulfonylamide structure is a particular group, the sulfonylamide structure is decomposed efficiently by an acid to provide a hydrophilic NH group.

Also, it has been found that the combined use of an N-sulfonylamide compound having a particular substituent group and an acid generator can solve the resolution deteriorating problem which is caused by lapse of time after exposure in a resist for micro-lithography use.

Further, it has been found that a printing plate having practical sensitivity to a visible light source and no scumming in the non-image area can be produced using the combination of an N-sulfonylamide compound having a particular substituent group with an acid generator.

Furthermore, it has been found that the combined use of an N-sulfonylamide compound, an acid generator and an infrared absorbing dye enables the production of a printing plate having practical sensitivity and no scumming in the non-image area.

Further, it has been found that, when a polymer having such N-sulfonylamide structures as to have a particular substituent on the nitrogen atom is used in combination with an acid generator, the resultant printing plate can have sensitivity high enough for practical use and generates no scum in the non-image area even when undergoes no development after exposure.

Furthermore, it has been found that, when a polymer having such N-sulfonylamide structures as to have a particular substituent on the nitrogen atom is used in combination with an acid generator and an infrared absorbing dye, the resultant printing plate can have practically sufficient sensitivities to laser beams in the infrared region and generates no scum in the non-image area.

Also, it has been found that the combination of an acid generator with an N-sulfonylamide polymer having particular groups as the substituents on the nitrogen atoms can provide a high-speed image forming composition which is sensitive to practically useful light sources and can also form images by undergoing conventional development-processing after exposure.

More specifically, it has been found that the problems described above can be solved by using the following constitutions [1] to [9], thereby achieving the present invention:
[1] A positive image forming composition comprising. (a) a compound generating an acid by undergoing the action of light or heat and (b) at least one compound selected from the N-sulfonylamide compounds represented by the following formula (I) or (II):

   L₁ - (SO₂ - NR₂ - CO - R₁)ₙ (I)

   L₁ - (CO - NR₂ - SO₂ - R₁)ₙ (II)

   wherein n is an integer of from 1 to 6; R₁ represents an aromatic group or an alkyl group; L₁ represents an aromatic group or an alkyl group when n is 1, or L₁ represents a polyvalent linkage group constituted of nonmetal atoms when n is from 2 to 6; and R₂ represents a tertiary alkyl group, an alkoxymethyl group, an arylmethyl group or an alicyclic alkyl group.
[2] A positive image forming composition according to the constitution [1], wherein the N-sulfonylamide compound of formula (I) or (II) contains as R₂ a t-butyl group or a 2,2-dimethyl-4,4-dimethylbutyl group.
[3] A positive image forming composition according to the constitution [1], wherein the N-sulfonylamide compound of formula (I) or (II) contains as R₂ a benzyloxymethyl group, a methoxymethyl group, a 1-ethoxyethyl group, a methoxyethoxymethyl group, a tetrahydropyranyl group or a tetrahydrofuranyl group.
[4] A positive image forming composition according to the constitution [1], wherein the N-sulfonylamide compound of formula (I) or (II) contains as R₂ a p-methoxybenzyl group, a 2,4,6-trimethoxybenzyl group, a piperonyl group or a 9-anthranylmethyl group.
[5] A positive image forming composition according to the constitution [1], wherein the N-sulfonylamide compound of formula (I) or (II) contains as R₂ a cyclohexyl group or a dibenzosuberyl group.
[6] A positive image forming composition according to any one of the constitutions [1] to [5], wherein the acid generating compound (a) is at least one compound selected from the group consisting of oxazole compounds having trihalomethyl substituents, s-triazine compounds having trihalomethyl substituents, iodonium salts, sulfonium salts, diazonium salts, disulfone compounds and iminosulfonate compounds.
[7] A positive image forming composition according to any one of the constitutions [1] to [6], further comprising a high molecular organic binder which is insoluble in water but soluble or at least swellable in an aqueous alkaline solution.
[8] A positive image forming composition according to any one of the constitutions [1] to [6], further comprising an infrared absorbing dye.
[9] An image forming composition comprising (a) a compound generating an acid by undergoing the action of light or heat and (c) a polymer having constitutional units represented by the following formula (III) in the main chain or side chains;

   - SO₂ - NR₃ - CO - (III)

   wherein R₃ represents a tertiary alkyl group, an alkoxymethyl group, an arylmethyl group or an alicyclic alkyl group.

In the mechanism of image formation by the use of a lithographic material according to the present invention, the particular substituent on the nitrogen atom in each sulfonylamide structure of an N-sulfonylamide compound or a polymer having N-sulfonylamido groups is split off the nitrogen atom by the action of the acid from an acid generator used together with the polymer to provide a hydrophilic NH group, and thereby the property of the film surface of the lithographic material is changed greatly from ink-receptivity to hydrophilicity. This change enables the solution of the scumming problem in the non-image area.

Further, the combined use of the present acid-decomposable N-sulfonylamide compounds and acid generators, especially those sensitive to light of wavelengths in the visible or/and infrared regions, can ensure high sensitivities to visible or/and infrared light, particularly to laser beams, in the positive image formation.

Moreover, the combined use of the present N-sulfonylamide polymer having particular substituents with an acid generator ensures high sensitivities to practically useful light sources, especially to light in the infrared region as well.

The present N-sulfonylamide compounds represented by the foregoing formula (I) or (II) are illustrated below.

The unsubstituted or substituted aromatic group represented by R₁ or L₁ in the case of n=1 includes aromatic hydrocarbon groups and aromatic heterocyclic groups. As for the aromatic hydrocarbon groups, aryl groups containing 6 to 19 carbon atoms can be used. Suitable examples thereof include aryl groups having from one to four benzene rings, such as a phenyl group, a naphthyl group, an anthracenyl group and a pyrenyl group. As for the aromatic heterocyclic groups, those containing from 3 to 20 carbon atoms and from 1 to 5 hetero atoms can be used. In particular, a pyridyl group, a furyl group and benzene-condensed aromatic heterocyclic groups, such as a quinolyl group, a benzofuryl group, a thioxanthonyl group and a carbazolyl group, are preferred over the others. The unsubstituted or substituted alkyl group represented by R₁ or L₁ in the case of n=1 includes alkyl groups containing 1 to 25 carbon atoms. In particular, straight-chain or branched alkyl groups containing 1 to 8 carbon atoms, such as a methyl group, an ethyl group, an isopropyl group and a t-butyl group, are preferred over the others.

When L₁ in the case of n=1 or R₁ represents a substituted aromatic hydrocarbon group, a substituted aromatic heterocyclic group or a substituted alkyl group, the substituent groups which can be present therein include alkoxy groups containing 1 to 10 carbon atoms, such as methoxy and ethoxy groups; halogen atoms, such as fluorine, chlorine and bromine atoms; halogen-substituted alkyl groups, such as trifluoromethyl and trichloromethyl groups; alkoxycarbonyl or aryloxycarbonyl groups containing 2 to 15 carbon atoms, such as methoxycarbonyl, ethoxycarbonyl, t-butyloxycarbonyl and p-chlorophenyloxycarbonyl groups; a hydroxyl group; acyloxy groups, such as acetyloxy, benzoyloxy and p-diphenylaminobenzoyloxy groups; carbonate groups, such as t-butyloxycarbonyloxy group; ether groups, such as t-butyloxycarbonylmethyloxy and 2-pyranyloxy groups; substituted and unsubstituted amino groups, such as amino, dimethylamino, diphenylamino, morpholino and acetylamino groups; thioether groups, such as methylthio and phenylthio groups; alkenyl groups, such as vinyl and styryl groups; a nitro group; a cyano group; acyl groups, such as formyl, acetyl and benzoyl groups; aryl groups, such as phenyl and naphthyl groups; and aromatic heterocyclic groups, such as a pyridyl group. In addition to the above-recited groups, alkyl groups such as methyl and ethyl groups can be contained as substituent groups in the substituted aromatic hydrocarbon group and the substituted aromatic heterocyclic group represented by R₁ or L₁ in the case of n=1.

When n is from 2 to 6, L₁ represents an optionally substituted polyvalent linkage group consisting of nonmetal atoms.

The polyvalent linkage group represented by L₁ is constituted of from 1 to 60 carbon atoms, from 0 to 10 nitrogen atoms, from 0 to 50 oxygen atoms, from 1 to 100 hydrogen atoms, and from 0 to 20 sulfur atoms. Specific examples of such a linkage group include combinations of two or more of the structural units illustrated below: 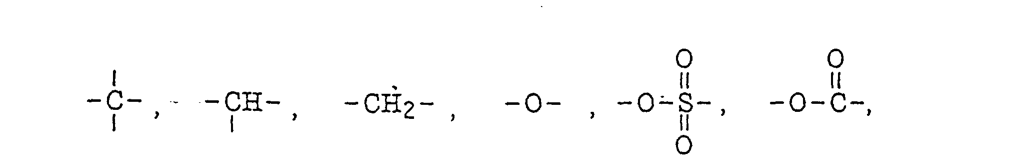 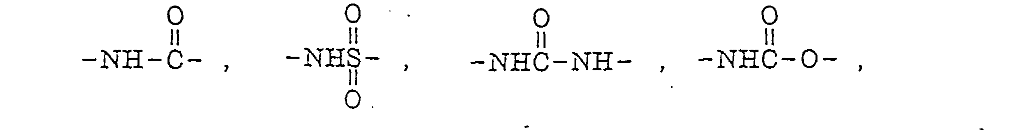 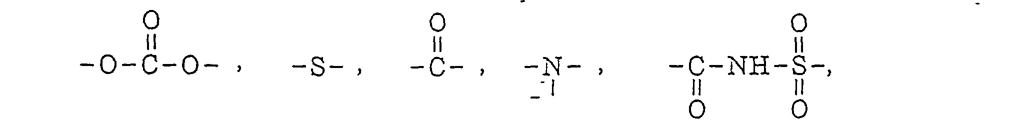 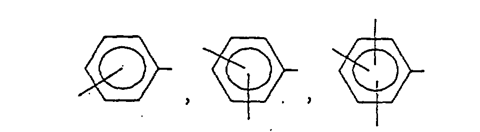 , a polyvalent naphthalene and a polyvalent anthracene.

Specific examples of a substituent group which can be present on the polyvalent linkage group as recited above include alkyl groups containing from 1 to 20 carbon atoms, such as methyl and ethyl groups; aromatic groups containing from 6 to 16 carbon atoms, such as phenyl and naphthyl groups; a hydroxyl group; a carboxyl group; a sulfonamido group; an N-sulfonylamido group; acyloxy groups containing from 1 to 6 carbon atoms, such as an acetoxy group; alkoxy groups containing from 1 to 6 carbon atoms, such as methoxy and ethoxy groups; halogen atoms, such as chlorine and bromine atoms; alkoxycarbonyl groups containing from 2 to 7 carbon atoms, such as methoxycarbonyl, ethoxycarbonyl and cyclohexyloxycarbonyl groups; a cyano group; and carbonate groups, such as a t-butyl carbonate group.

The molecular weight of a compound represented by formula (I) or (II) ranges from 400 to 5,000, preferably from 500 to 3,000.

As for the tertiary alkyl group represented by R₂, those containing from 4 to 20 carbon atoms, such as a t-butyl group and a 2,2-dimethyl-4,4-dimethylbutyl group, are examples thereof.

As for the alkoxy moiety of the substituted or unsubstituted alkoxymethyl group represented by R₂, alkoxy groups containing from 1 to 6 carbon atoms, such as methoxy and ethoxy groups, are examples thereof. As for the group by which the alkoxy moiety can be substituted, alkyl groups containing from 1 to 6 carbon atoms, alkoxy groups and aromatic groups such as phenyl and naphthyl groups are examples thereof. Additionally, the substituted alkoxymethyl group can be a group dividing into branches at the site of the carbon atom linking with the nitrogen atom, such as 1-ethoxy-ethyl, 1-t-butoxy-ethyl, tetrahydrofuranyl or tetrahydropyranyl group.

Of those alkoxymethyl groups, a methoxymethyl group, a 1-ethoxyethyl group, a methoxyethoxymethyl group, a benzyloxymethyl group, a tetrahydrofuranyl group and a tetrahydropyranyl group are preferred in particular.

As for the aryl moiety of the substituted or unsubstituted arylmethyl group represented by R₂, aryl groups containing from 6 to 14 carbon atoms, such as phenyl, naphthyl and anthranyl groups, are examples thereof.

As examples of a group by which the aryl moiety can be substituted, mention may be made of alkoxy groups containing from 1 to 4 carbon atoms and alkyl groups containing from 1 to 4 carbon atoms.

Specific examples of the substituted or unsubstituted arylmethyl group as mentioned above include a p-methoxybenzyl group, a 2,4,6-trimethylbenzyl group, a piperonyl group and a 9-anthranylmethyl group.

As a substituted or unsubstituted alicyclic alkyl group represented by R₂, those containing from 5 to 7 carbon atoms can be employed. Examples of a substituent group which can be present on such groups include a methoxy group, a phenyl group, a halogen atom and a benzene ring fused together with the aliphatic ring.

The groups suitable for the foregoing substituted or unsubstituted alicyclic alkyl group are a cyclohexyl group and a dibenzosuberyl group.

Specific examples of N-sulfonylamide compounds used in the present invention are illustrated below, but these examples are not to be construed as limiting the scope of the invention in any way.

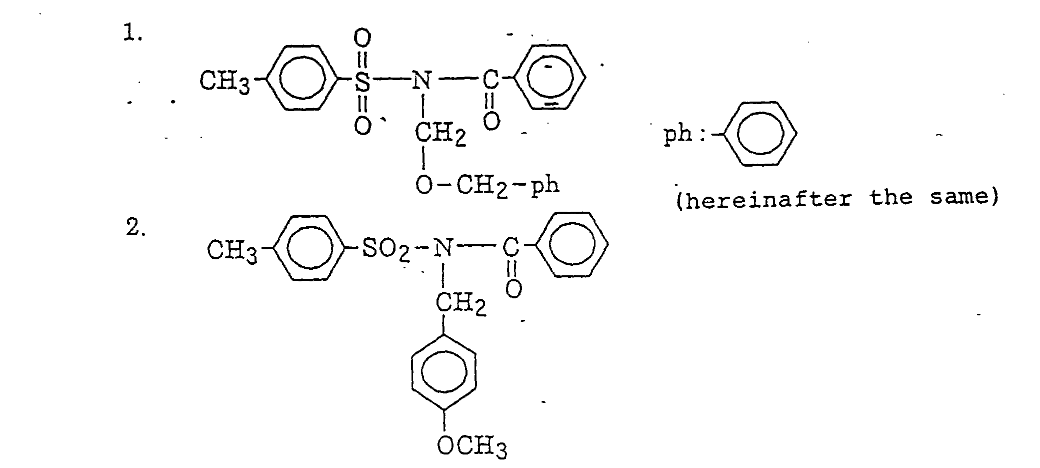

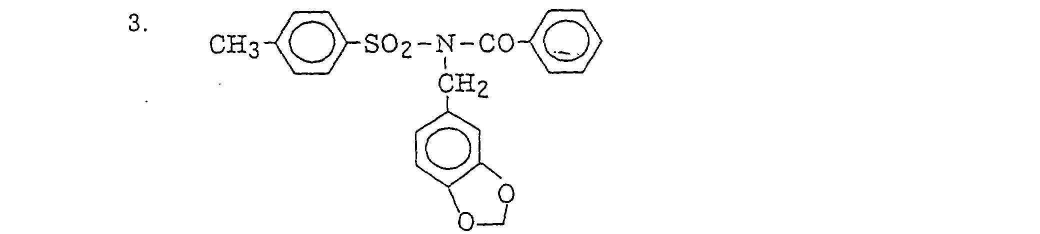

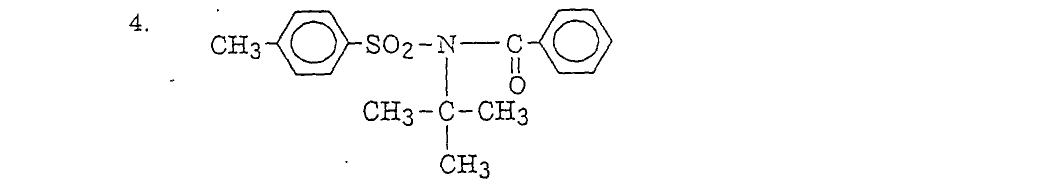

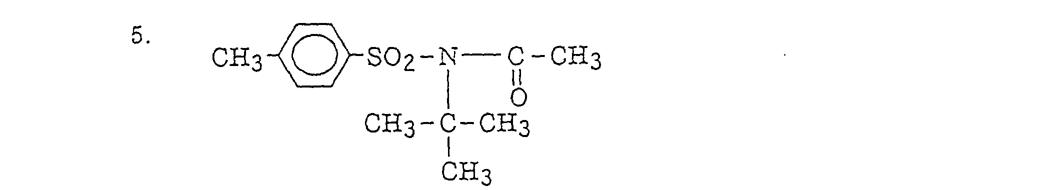

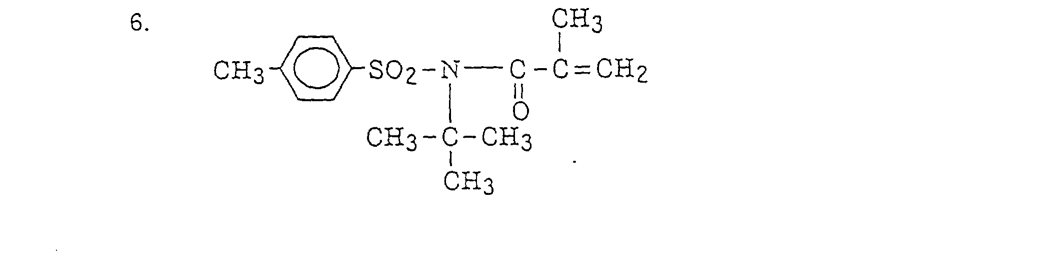

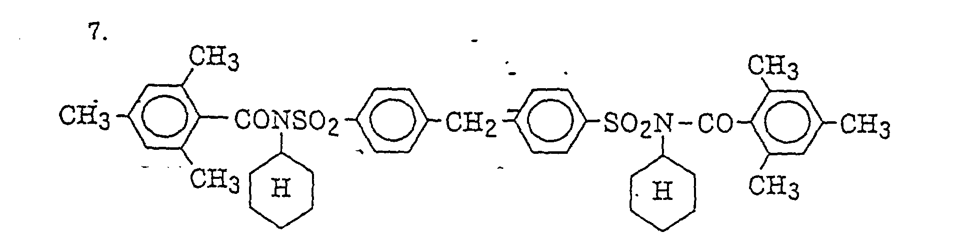

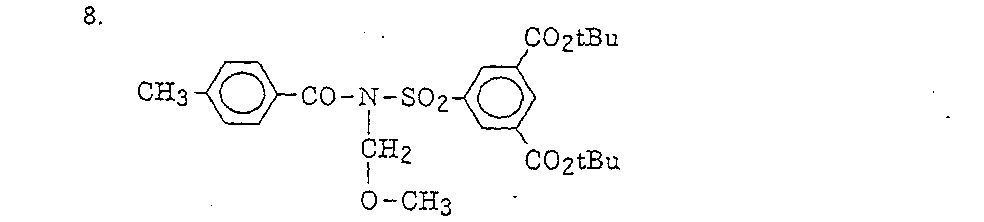

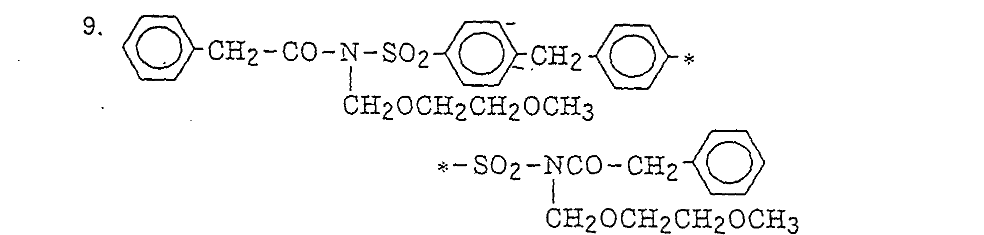

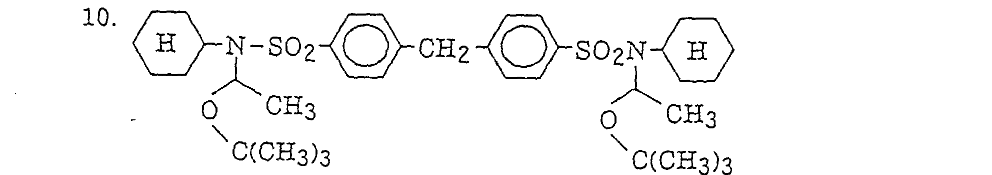

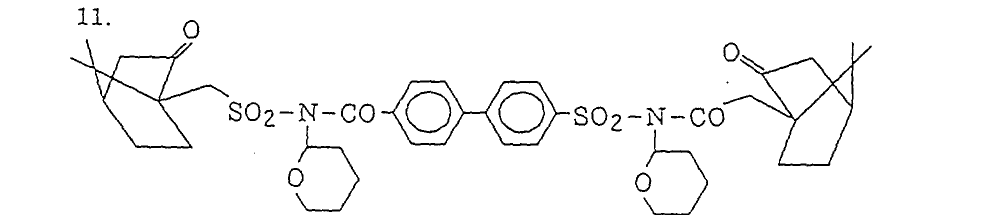

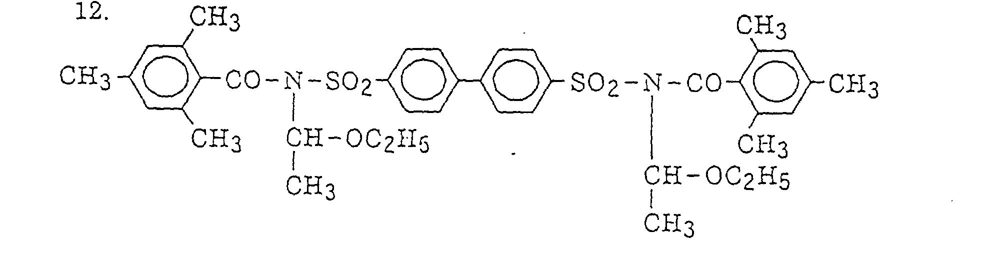

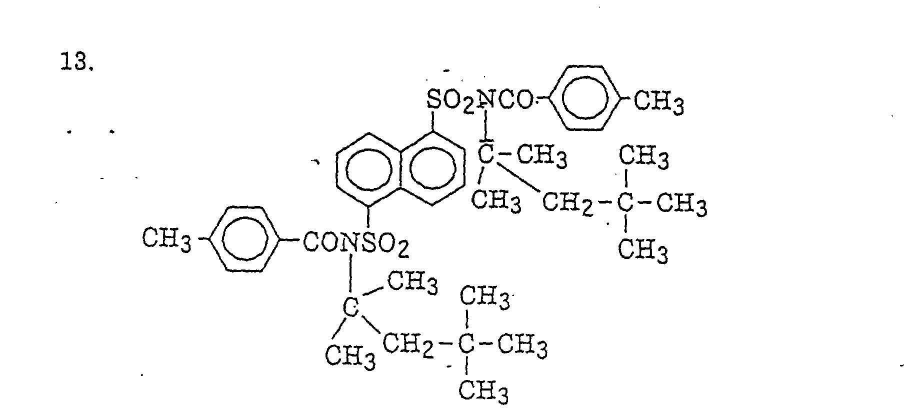

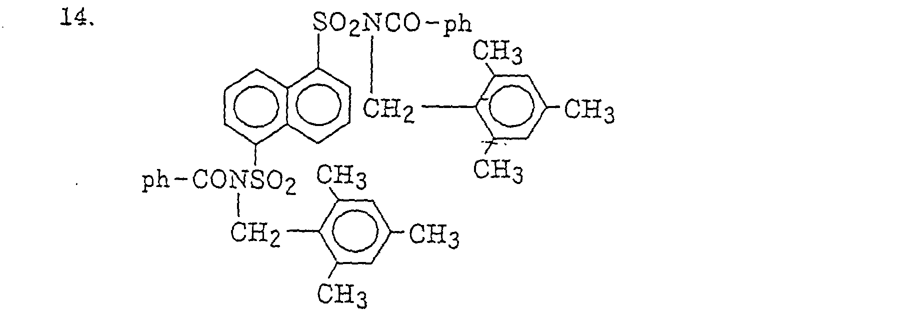

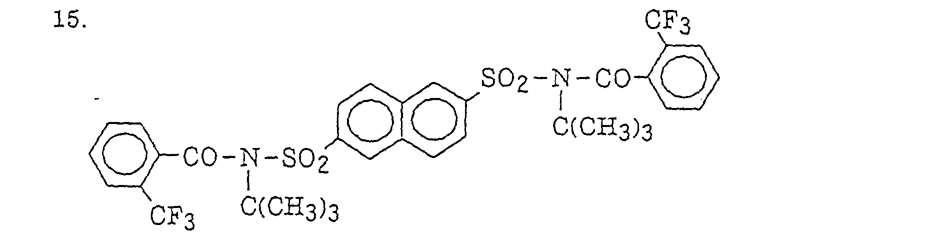

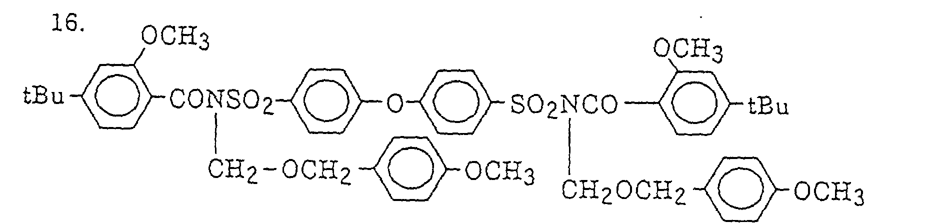

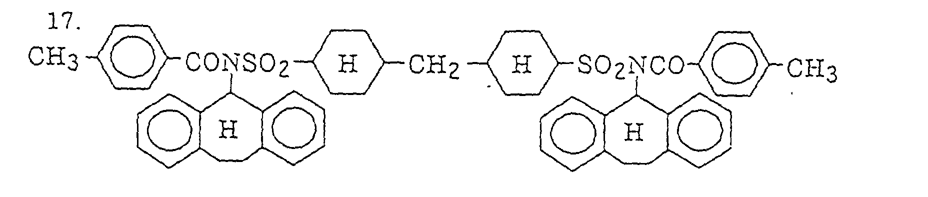

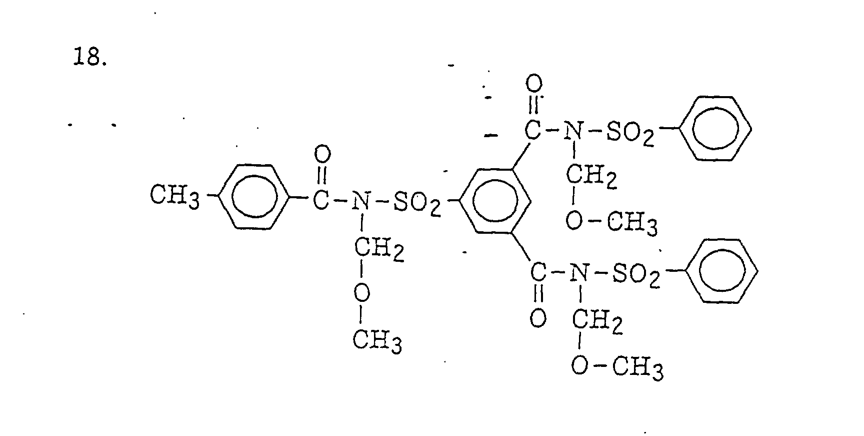

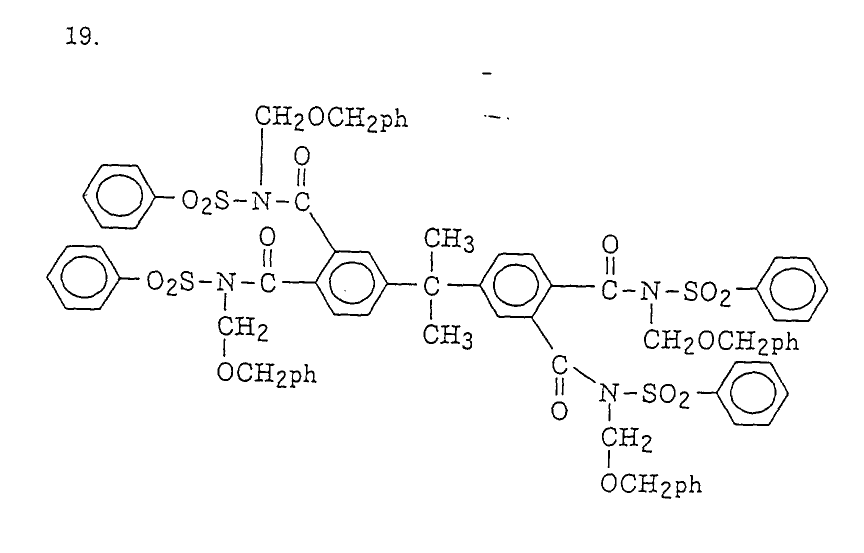

Synthesis examples of the N-sulfonylamide compounds used in the present invention are described below.

### Synthesis Example A-1

### Synthesis of Compound 1 exemplified above:

In a three necked flask, 13.7 g of N-(p-toluenesulfonyl)benzamide and 200 ml of N,N-dimethylacetamide were placed, and stirred at room temperature. Thereto, 5 g of triethylamine was added with stirring. At the conclusion of the addition of triethylamine, 10.9 g of benzyl chloromethyl ether was further added. Then, the stirring was continued for 2 hours, and the resulting reaction solution was poured into water to yield crystals. These crystals were filtered off, and recrystallized from a hexane-toluene mixture. Thus, white crystals were obtained in the amount of 16 g. mp. 99-101°C.

### Synthesis Example A-2

### Synthesis of Compound 4 exemplified above:

In a 2-liter three necked flask, 9.0 g of N-(t-butyl)-p-toluenesulfonylamide and 100 ml of N,N-dimethylacetamide were placed, and thereto was added 2.0 g of sodium hydride (60 % oily solution). Further, 6.75 g of benzoyl chloride was added dropwise with stirring as the mixture was cooled in an ice bath. After the dropwise addition was concluded, the stirring was continued for additional two hours. Then, the ice bath was taken away, and the reaction mixture was further stirred for 5 hours at room temperature. The resultant reaction solution was admixed with 500 ml of water, and extracted with 0.5 liter of ethyl acetate. The oil thus obtained was purified with a silica gel column. Yield 4.2 g, mp. 73-78°C.

The appropriate proportion of the present compound represented by formula (I) or (II) in the total composition (excluding a coating solvent) is from 5 to 95 weight %, preferably from 10 to 70 weight %, and more preferably from 15 to 60 weight %.

The polymers having the constitutional units represented by the foregoing formula (III) in the present invention are illustrated below in detail.

The term "polymer" as used herein refers to a macromolecule which is derived by mutually combining many, e.g., 10, 100, 1000 or more, smaller molecules and has a molecular weight of from about thousands to about millions. The smaller molecules to be combined mutually are generally called "monomers" or "prepolymers", and the mutual combination reaction of such molecules is generally called "polymerization". The structure of a polymer is shown using one or more of an appropriate constitutional repeating unit, which is, in many cases, the structural formula of a monomer or prepolymer as a starting material. The details of the chemical properties, the reaction, the constituent monomers, the characteristics and the nomenclature of a polymer are given in Odian, Principles of Polymerization, 2nd Ed., John Wiley and Sons, New York (1981), and Encyclopedia of Polymer Science and Engineering, John Wiley and Sons, New York (1988). The term "polymer" includes both homopolymer (wherein all the monomer units are the same) and copolymer (wherein two or more kinds of monomer units are present).

The present constitutional unit represented by the foregoing formula (III) may be present in the main chain or side chains of a polymer.

The tertiary alkyl group represented by R₃ in formula (III) is an unsubstituted tertiary alkyl group having 4 to 20 carbon atoms or a substituted tertiary alkyl group. Suitable examples of such a tertiary alkyl group include a t-butyl group and a 2,2-dimethyl-4,4-dimethylbutyl group. As for the substituents which can be present on those groups, a halogen atom such as chlorine or bromine, an alkoxy group and an aromatic group such as phenyl or naphthyl group are examples thereof.

When R₃ represents a substituted or unsubstituted alkoxymethyl group, the alkoxy moiety of such a group includes those containing 1 to 6 carbon atoms, such as methoxy and ethoxy groups. As for the substituent present on such an alkoxymethyl group, an alkyl group containing 1 to 6 carbon atoms, an alkoxy group and an aryl group, such as a phenyl or naphthyl group, are examples thereof. In the substituted alkoxymethyl group, groups having the carbon atom attached to the nitrogen atom at a branch point, such as 1-t-butoxy-ethyl, tetrahydrofuranyl and tetrahydropyranyl groups, are also included.

Of those alkoxymethyl groups, methoxyethoxymethyl, benzyloxymethyl, tetrahydrofuranyl, tetrahydropyranyl, methoxymethyl, ethoxymethyl and 1-ethoxyethyl groups are preferred in particular.

The aryl moiety of a substituted or unsubstituted arylmethyl group represented by R₃ includes aryl groups having 6 to 14 carbon atoms, such as phenyl, naphthyl and anthranyl groups.

As for the substituent present in the substituted arylmethyl group, an alkoxy group having 1 to 4 carbon atoms and an alkyl group having 1 to 4 carbon atoms are examples thereof.

Specific examples of such a substituted or unsubstituted arylmethyl group include p-methoxybenzyl, 2,4,6-trimethylbenzyl, piperonyl and 9-anthranylmethyl groups.

When R₃ is a substituted or unsubstituted alicyclic alkyl group, the alicyclic alkyl group includes those having 5 to 7 carbon atoms. As for the substituent(s) such a group can have, a methoxy group, a phenyl group, a halogen atom and a benzene ring fused together with the aliphatic ring are examples thereof.

Suitable examples of a substituted or unsubstituted alicyclic alkyl group include a cyclohexyl group and a dibenzosuberyl group.

When the present polymer has the constitutional units of formula (III) in the form of at least one moiety selected from those represented by the following formulae (IV), (V) and (VI), the image forming composition of the present invention can achieve more favorable effects:

- L₃ - SO₂ - NR₃ - CO - L₄ - (IV)

- L₃ - SO₂ - NR₃ - CO - R₄ (V)

R₄ - SO₂ - NR₃ - CO - L₃ - (IV)

wherein R₄ represents an aromatic group or an alkyl group; L₃ and L₄ are the same or different, and each of them represents a polyvalent organic group which is constituted of nonmetal atoms and links the constitutional unit of the formula (IV), (V) or (VI) to the polymer skeleton; and R₃ represents a tertiary alkyl group, an alkoxymethyl group, an arylmethyl group or an alicyclic alkyl group.

The present polymers having constitutional units represented by the foregoing formulae (IV) to (VI) are illustrated below.

The unsubstituted or substituted aromatic group represented by R₄ includes both carbocyclic and heterocyclic aromatic groups. As for the carbocyclic aromatic group, those having 6 to 19 carbon atoms are examples thereof. Preferably, those having 1 to 4 benzene rings, such as a phenyl group, a naphthyl group, an anthracenyl group and a pyrenyl group, can be employed. As for the heterocyclic aromatic group, those having 3 to 20 carbon atoms and 1 to 5 hetero atoms, such as oxygen, sulfur and nitrogen atoms, are examples thereof. In particular, a pyridyl group, a furyl group and benzene-condensed ring residues, such as a quinolyl group, a benzofuryl group, a thioxanthonyl group and a carbazolyl group, are preferred over the others. When R₄ represents an unsubstituted or substituted alkyl group, the alkyl group includes those having 1 to 25 carbon atoms. Of these alkyl groups, straight-chain or branched alkyl groups having 1 to 8 carbon atoms, such as a methyl group, an ethyl group, an isopropyl group and a t-butyl group, are preferred in particular.

When R₄ is a substituted carbocyclic aromatic group, a substituted heterocyclic aromatic group or a substituted alkyl group, the substituents of those groups include alkoxy groups having 1 to 10 carbon atoms, such as a methoxy group and an ethoxy group; halogen atoms, such as a fluorine atom, a chlorine atom and a bromine atom; halogen-substituted alkyl groups, such as a trifluoromethyl group and a trichloromethyl group; alkoxycarbonyl or aryloxycarbonyl groups having 2 to 15 carbon atoms, such as a methoxycarbonyl group, an ethoxycarbonyl group, a t-butyloxycarbonyl group and a p-chlorophenyloxycarbonyl group; a hydroxyl group; acyloxy groups, such as an acetyloxy group, a benzoyloxy group and a p-diphenylaminobenzoyloxy group; carbonate groups, such as a t-butyloxycarbonyloxy group; ether groups, such as a t-butyloxycarbonylmethyloxy group and a 2-pyranyloxy group; substituted and unsubstituted amino groups, such as an amino group, a dimethylamino group, a diphenylamino group, a morpholino group and an acetylamino group; thioether groups, such as a methylthio group and a phenylthio group; alkenyl groups, such as a vinyl group and a styryl group; a nitro group; a cyano group; acyl groups, such as a formyl group, an acetyl group and a benzoyl group; aryl groups, such as a phenyl group and a naphthyl group; and heterocyclic aromatic groups, such as a pyridyl group. Additionally, alkyl groups, such as a methyl group and an ethyl group, can further be included in the examples of a substituent present in a substituted carbocyclic or heterocyclic aromatic group represented by R₄.

The polyvalent linkage group constituted of nonmetal atoms which is represented by L₃ or L₄ is intended to include those constituted of 1 to 60 carbon atoms, 0 to 10 nitrogen atoms, 0 to 50 oxygen atoms, 1 to 100 hydrogen atoms and 0 to 20 sulfur atoms. Specifically, the linkage groups formed by combining two or more of the following structural units are examples of L₃ and L₄. 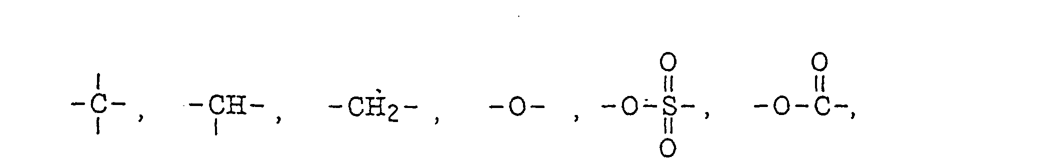 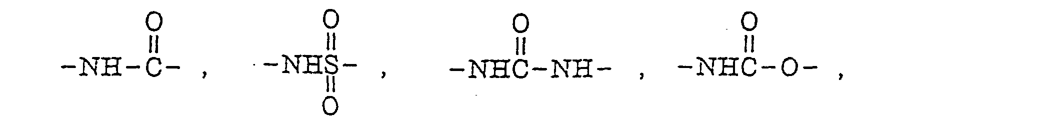 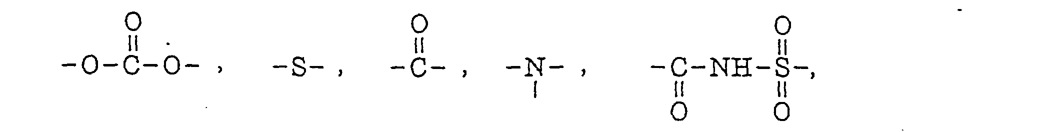 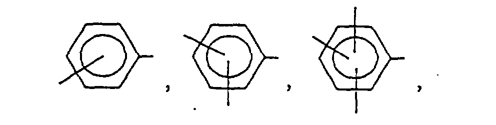 polyvalent naphthalene, polyvalent anthracene.

When the polyvalent linkage group has substituent(s), examples of such substituent(s) include alkyl groups having 1 to 20 carbon atoms, such as methyl and ethyl groups; aryl groups having 6 to 16 carbon atoms, such as phenyl and naphthyl groups; a hydroxyl group; a carboxyl group; a sulfonamido group; an N-sulfonylamido group; acyloxy groups having 1 to 6 carbon atoms, such as an acetoxy group; alkoxy groups having 1 to 6 carbon atoms, such as methoxy and ethoxy groups; halogen atoms, such as chlorine and bromine atoms; alkoxycarbonyl groups having 2 to 7 carbon atoms, such as methoxycarbonyl, ethoxycarbonyl and cyclohexyloxycarbonyl groups; a cyano group; and carbonate groups, such as a t-butylcarbonate group.

The present polymers having constitutional units represented by the foregoing formula (III) can be synthesized usually by polymerizing monomeric units which have various reactive groups on the moieties corresponding to the linkage group L₃ or L₄.

Therein, L₃ or L₄ is linked to a reacting or polymerizing group useful for the polymerization reaction to produce a polymer having the constitutional units represented by the foregoing formulae (IV) to (VI). Typical examples of a reacting group which is linked to L₃ or L₄ and useful for the polymerization reaction include a hydroxyl group; an isocyanate group; an amine; a carboxyl group; groups derived from vinyl monomers, such as an acrylate, a methacrylate, a vinyl ester, an acrylamide, a methacrylamide and styrene; and groups derived from cyclic ethers: which are not to be considered as limiting the scope of the invention. In another case, L₃ or L₄ is chosen so as to contain a reacting group capable of combining with functional groups attached to a previously prepared polymer. Examples of such a reacting group include an isocyanate group, a hydroxyl group, an amino group, a carboxyl group, an acid anhydride and an epoxy group. However, the reacting groups employable herein should not be construed as being limited to those examples.

Most of general polymers can be synthesized using monomers wherein the above-recited reacting groups useful for polymerization reaction are linked to L₃ or L₄ of the structural units represented by the foregoing formulae (IV) to (VI) and polymerizing them so that those structural units constitute the side chains or are incorporated in the main chains. Specific examples of a general polymer include polyacrylate, polymethacrylate, polyacrylamide, polystyrene, acrylonitrile-styrene copolymers, butadiene-styrene copolymers, polyolefins (such as polyethylene, polypropylene and polyisobutylene), polyester, polyether, polycarbonate, polyurethane, polysiloxane, polyamide, phenol resins, poly(arylmethylene), polyacrylonitrile, polybutadiene, polyvinyl esters, polyvinyl alcohol, polyvinyl acetal, polyvinyl ethers, polyvinyl pyrrolidone, polyvinyl pyridine, polyvinyl chloride, polyethylene oxide, polypropylene oxide, polyethylene glycol, polypropylene glycol, polyethyleneimine, epoxy resins, phenoxy resins, polytetrahydrofuran, polycaprolactone, poly(styrenesulfonic acid), gelatin, alkyl cellulose, hydroxyalkyl cellulose, carboxymethyl cellulose, starch and polysaccharide. However, these examples are not to be considered as limiting on the scope of the invention. The molecular weight of such a polymer can be in the range of thousands to millions.

Of those polymers, polyacrylate, polymethacrylate, polyacrylamide, polystyrene, polyester, polyurethane, phenol resins and epoxy resins are preferred over the others.

In a group of polymers well suited for the present invention, acrylic acid polymers, methacrylic acid polymers, polystyrenes and acrylamide polymers can be included because of their diversity in structure, their ease of syntheses, their good physical properties, and their capacity to provide satisfactory performances. A suitable method for preparation of the polymer as recited above consists in free radical polymerization of the structural unit of formula (III) which has in a combined state a monomer moiety, such as an acrylate, methacrylate, acrylamide, methacrylamide or styrene moiety. Specific examples of such a monomer-substituted structural unit (N-sulfonylamide monomer) are illustrated below:

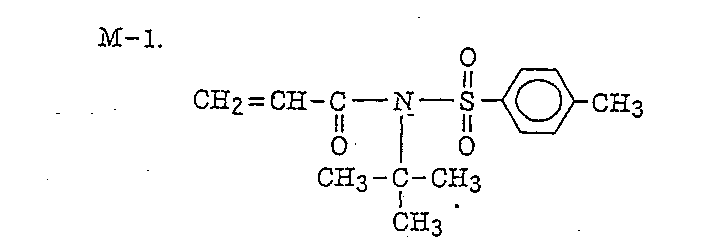

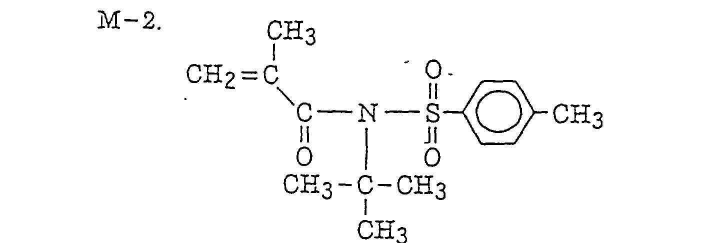

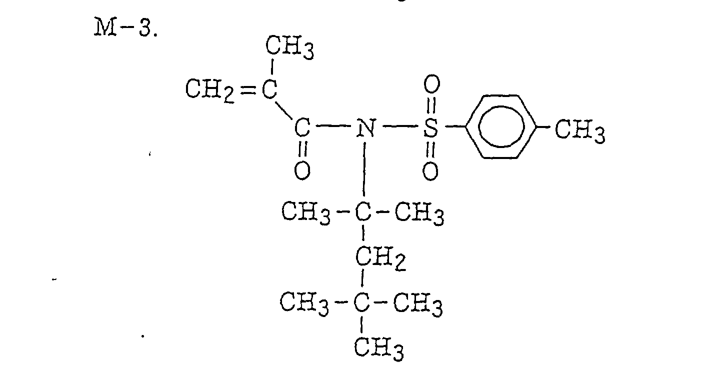

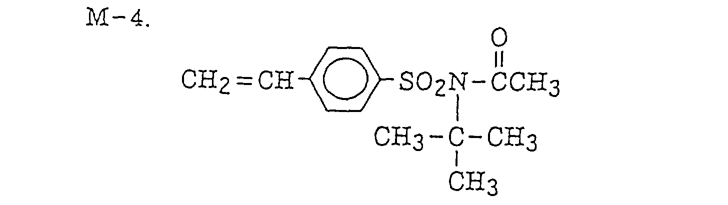

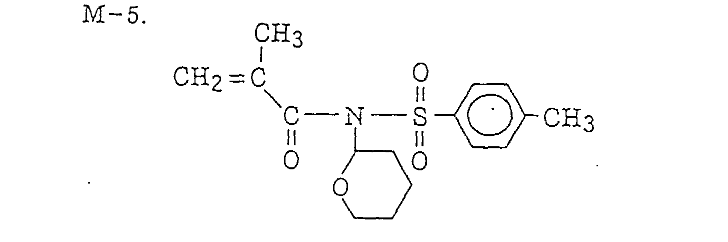

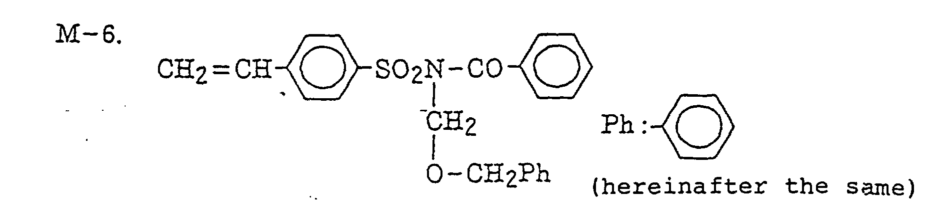

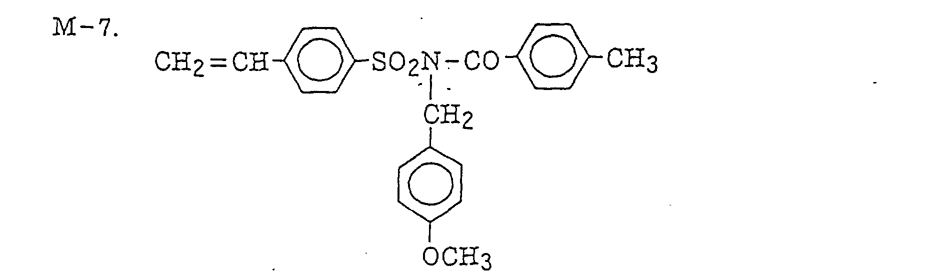

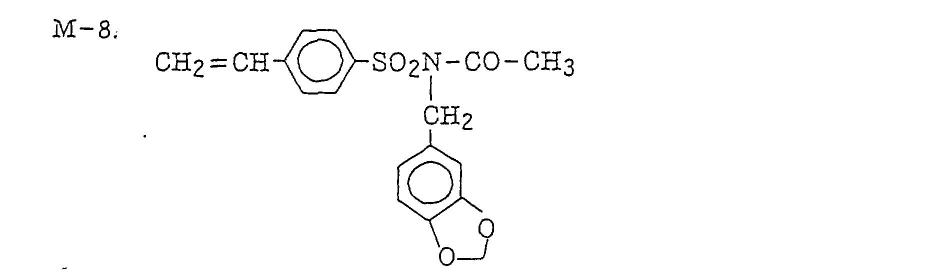

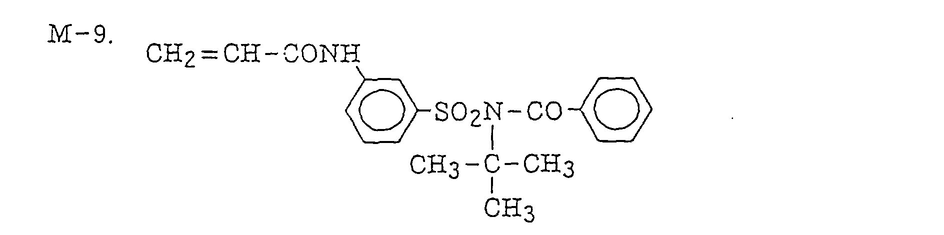

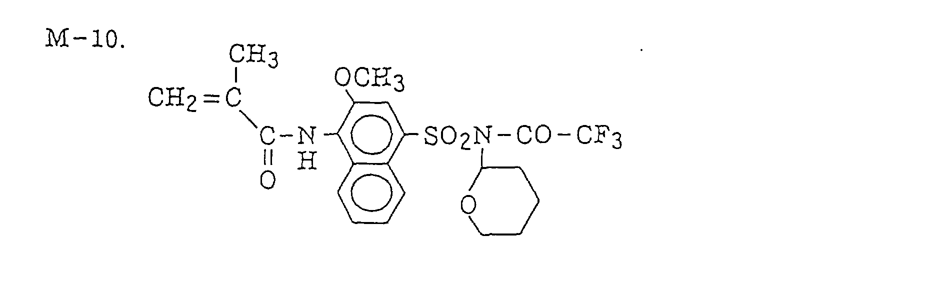

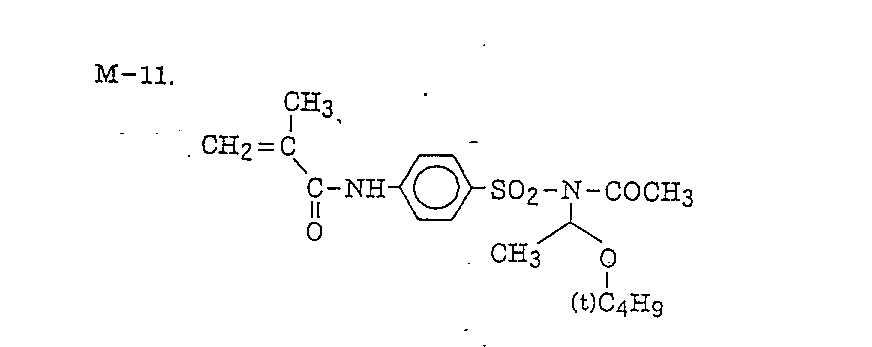

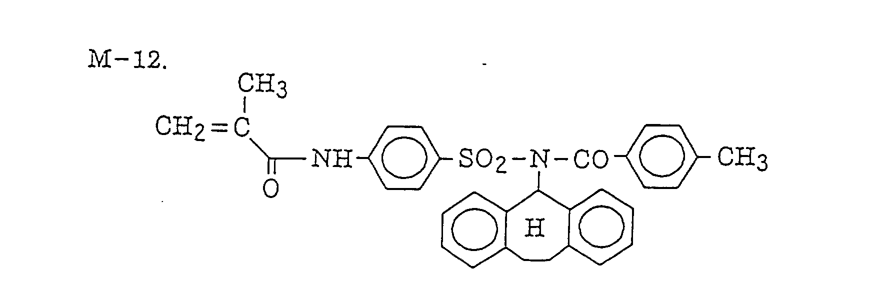

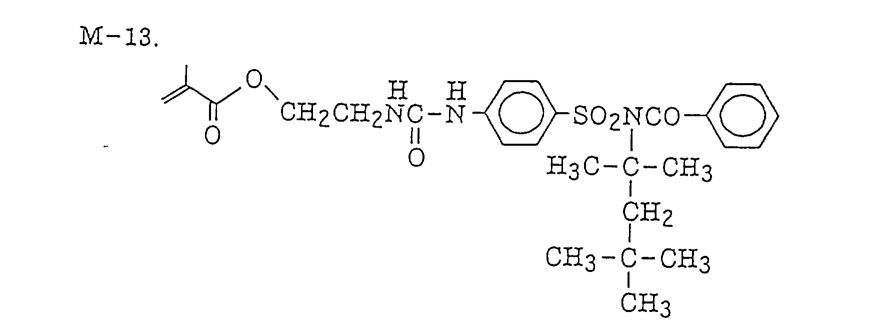

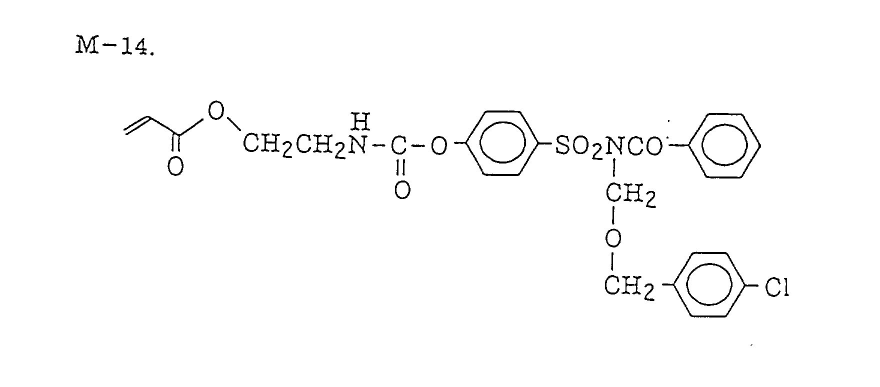

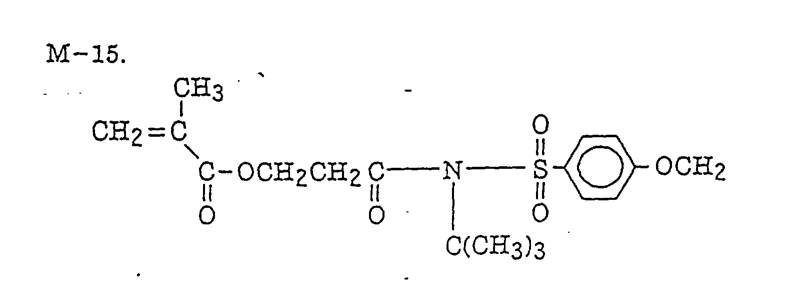

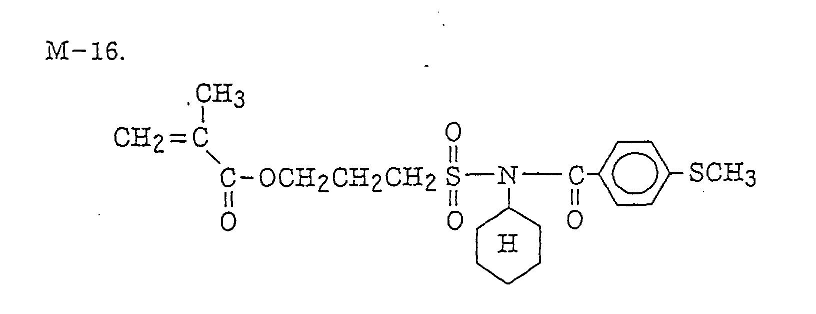

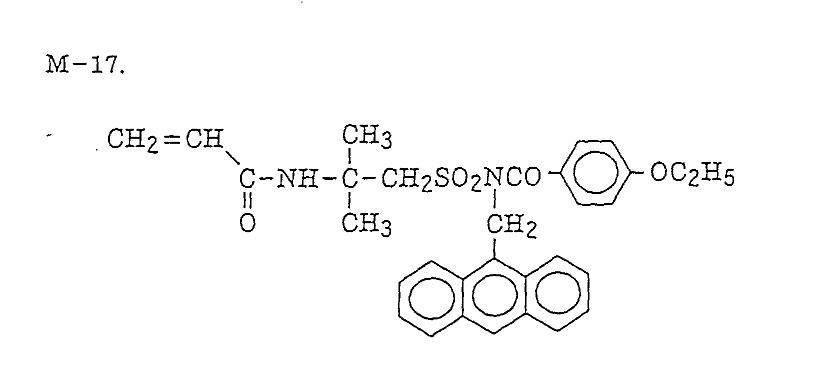

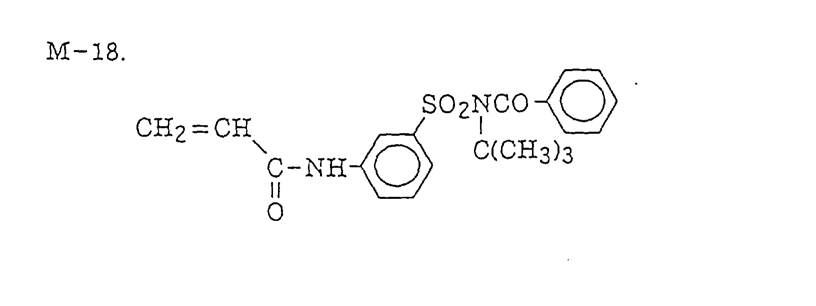

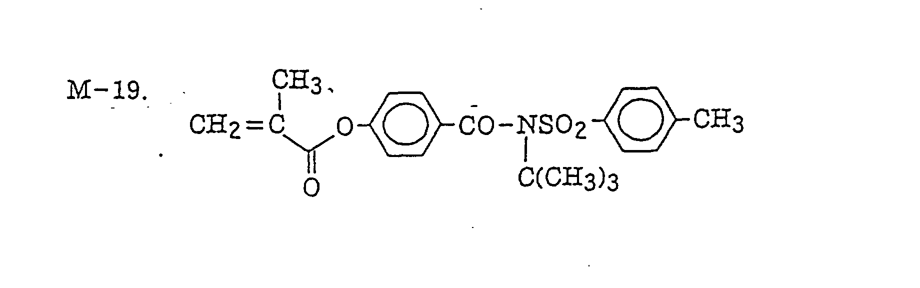

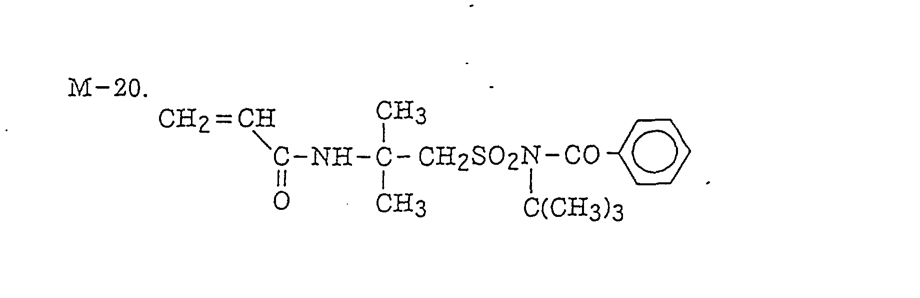

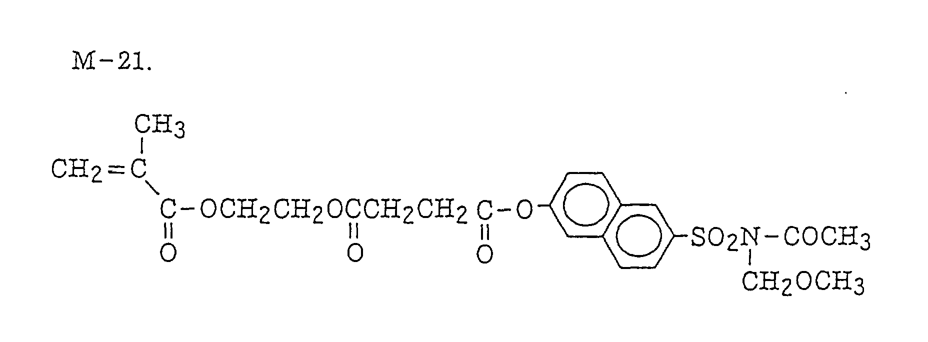

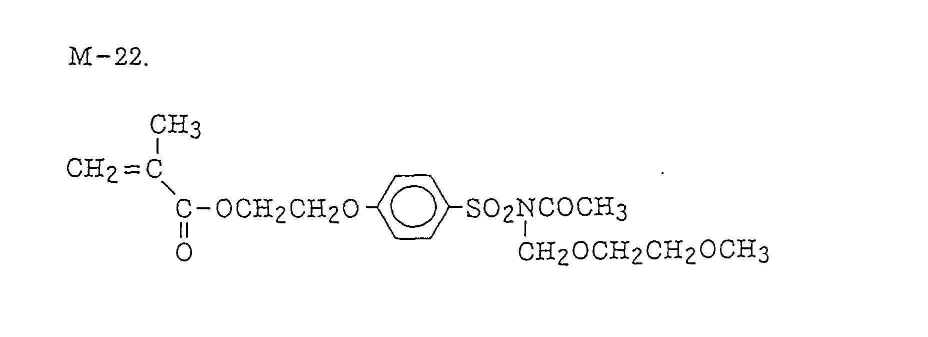

Specific examples of a comonomer useful for copolymerization reaction with the N-sulfonylamide monomer as recited above include acrylic or methacrylic acid; acrylic or methacrylic acid esters (e.g., methyl acrylate or methacrylate, ethyl acrylate or methacrylate, butyl acrylate or methacrylate, octyl acrylate or methacrylate, 2-dimethylaminoethyl acrylate or methacrylate, 2-methoxyethyl acrylate or methacrylate, 2-hydroxyethyl acrylate or methacrylate, 2-chloroethyl acrylate or methacrylate, benzyl acrylate or methacrylate, glycidyl acrylate or methacrylate, 2-cyanoethyl acrylate or methacrylate, 2-isocyanatoethyl acrylate or methacrylate, tetrahydrofurfuryl acrylate or methacrylate); acrylamide and derivatives thereof (e.g., N-methylolacrylamide, N-isobutoxymethylacrylamide, methacrylamide); trialkoxysilanes having vinyl groups, such as methacryloyloxypropyltrimethoxysilane; styrene; maleic anhydride; 4-vinylpyridine; 2-methacryloyloxyethane-1-sulfonic acid and salts thereof; acrylonitrile; and vinyl ethers, such as ethyl vinyl ether. However, these examples are not to be considered as limiting on the scope of the invention. Other examples of an acrylic monomer and an acrylamide monomer are recited in Encyclopedia of Polymer Science, 2nd Ed., vol. 1, pp. 182, 204, 237, 242 and 243.

As another group of polymers which are useful because of their ease of syntheses and their excellent diversity, mention may be made of polyurethanes prepared from diols, diisocyanates and chain extenders. In the preparation of such polymers, particularly useful reactants are N-sulfonylamide derivatives having dihydroxyl or diisocyanate groups. These dihydroxyl derivatives are used directly or after the conversion into diisocyanate prepolymers by the reaction with tolylene-2,4-diisocyanate. Other diols, such as terminal hydroxyl-containing straight-chain aliphatic polyesters and aliphatic polyethers, and other polycyclic diisocyanates, such as aromatic, aliphatic, alicyclic or polycyclic diisocyanates, can be used in combination. Due to such diversity in selection of reactants, it is allowed to prepare polymers of a wide variety of molecular weight and desired physical properties. The arts, chemical properties, fundamental structures and synthesis paths of polyurethane elastomers are summarized in C. Hepburn, Polyurethane Elastomers, Applied Science Publishers, New York (1982), and Encyclopedia of Polymer Chemical Industry, 2nd. Ed., vol. 13, pp. 243-303.

As examples of other useful polymers, mention may be made of polyesters. The polyesters can be synthesized by reference to F.W. Billmeyer, Textbook of Polymer Science, John Wiley and Sons, New York (1984), and so on. Specific examples of a substituted N-sulfonylamide which can be advantageously used as a starting material for the synthesis of polyurethane or polyester are illustrated below:

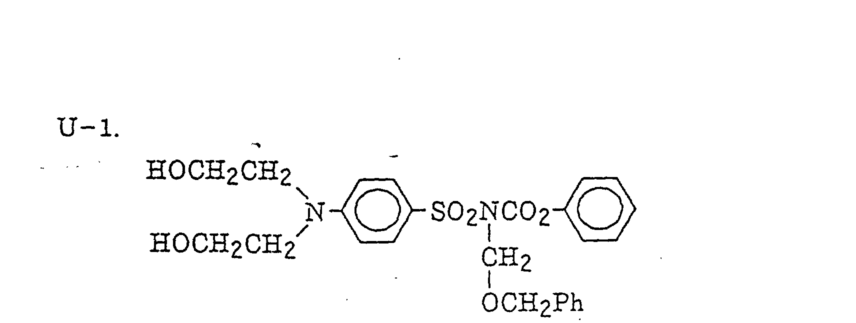

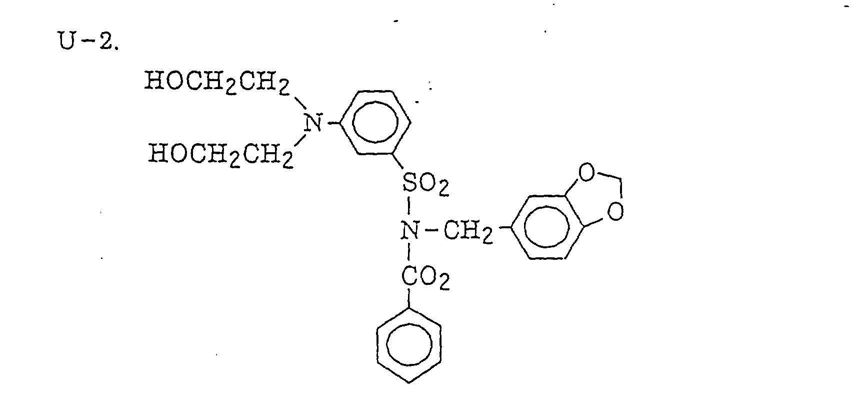

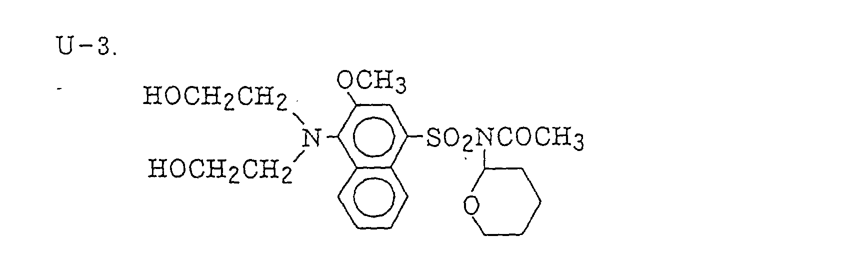

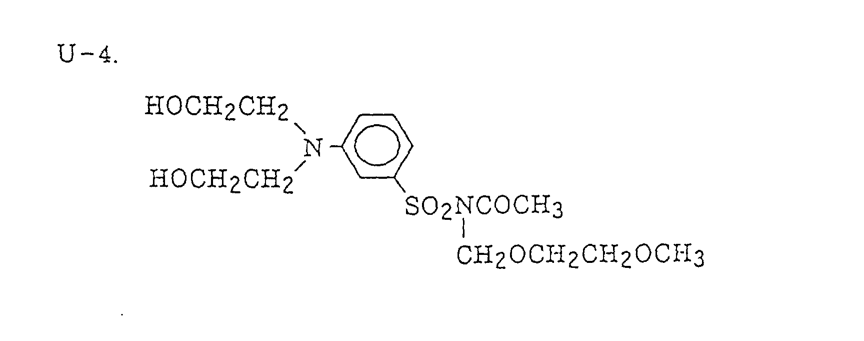

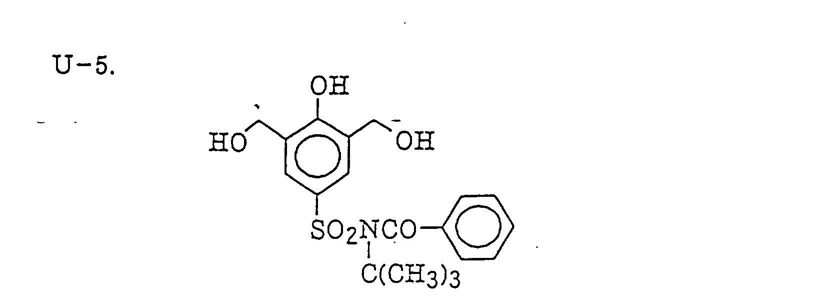

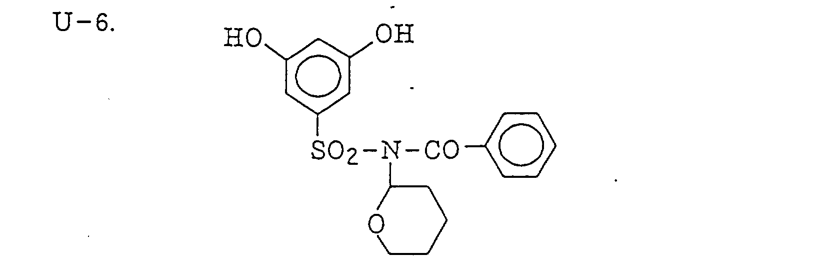

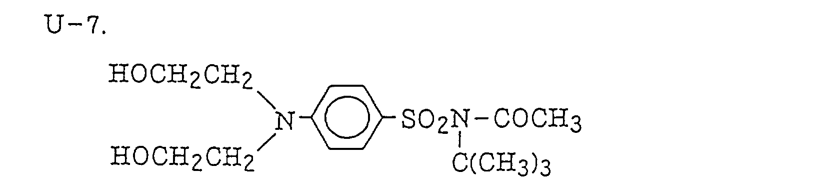

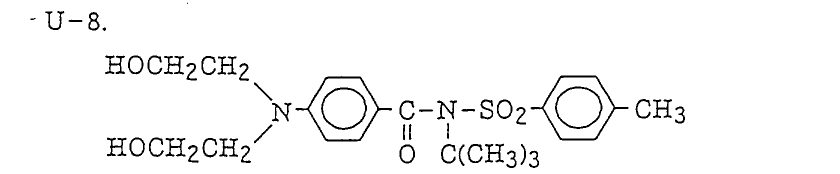

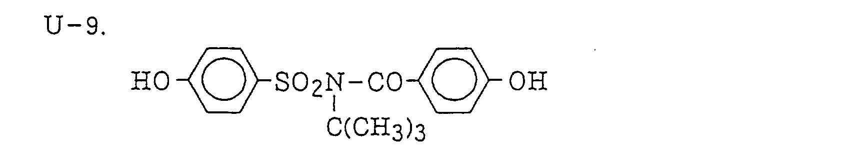

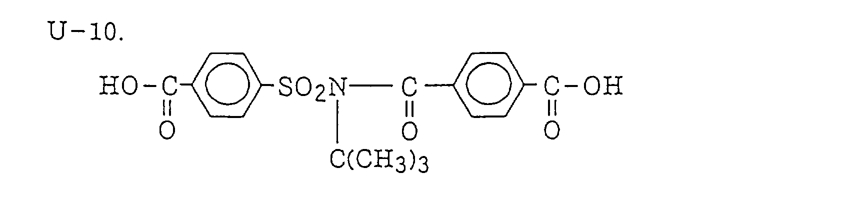

However, the compounds illustrated above should not be considered as limiting on the scope of the substituted N-sulfonylamide compounds suitable for the present invention.

The proportion of the total N-sulfonylamide groups (-SO₂NR₃CO-) in the present polymer can be from 0.01 to 99 % by weight. From the practical point of view, however, it is in the range of 0.1 to 98 % by weight.

The weight-average molecular weight of the present polymer is generally from about 1,000 to about 1,000,000, but can exceed such a limit. Preferably, the present polymer has its molecular weight in the range of about 5,000 to about 1,000,000.

The present constitutional units represented by formula (III) can be incorporated in both side chains and main chain of a polymer as well as in either the side chains or the main chain of a polymer.

Specific examples of a polymer having constitutional units of formula (III) used in the present invention are illustrated below. However, the invention should not be construed as being limited to these examples.

Additionally, the figures in the following structural formula are mole fractions.

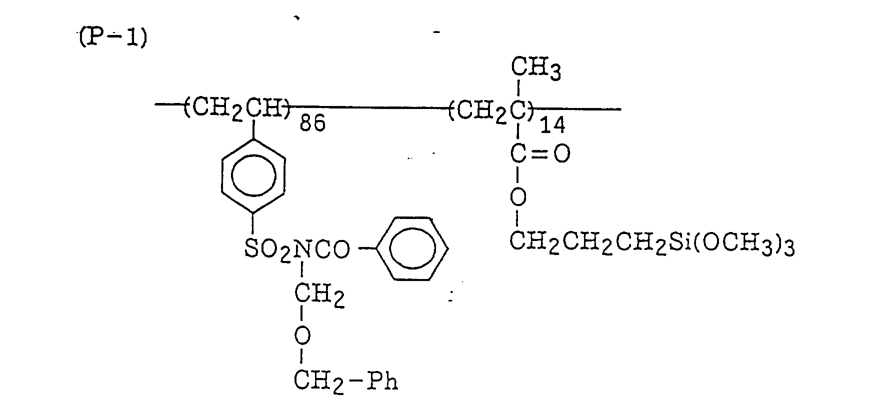

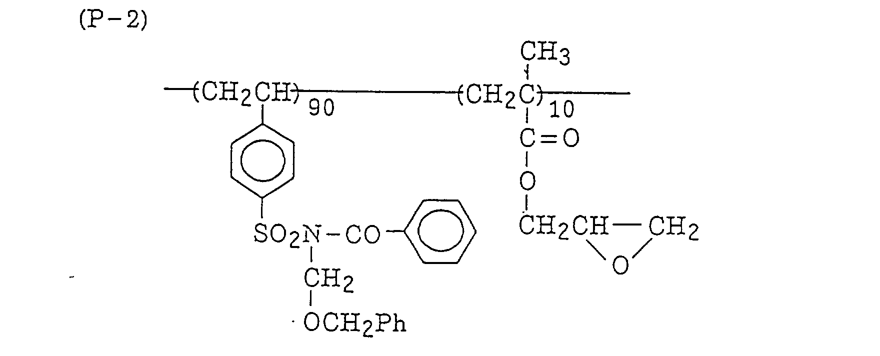

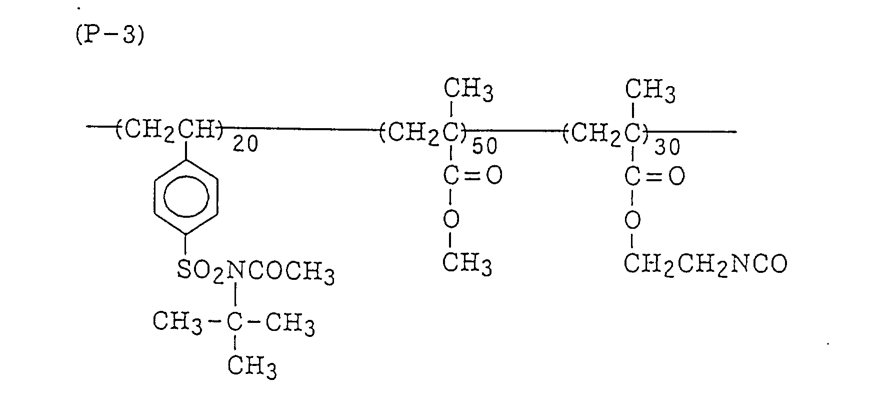

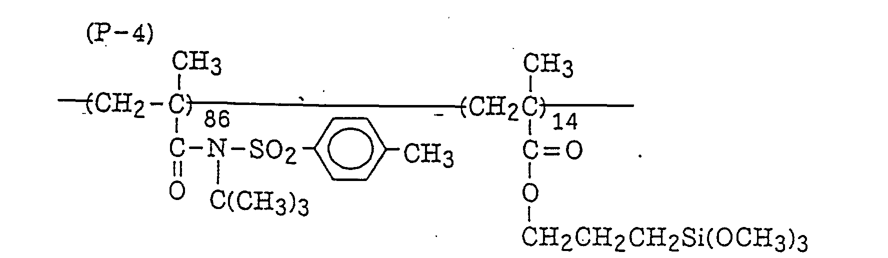

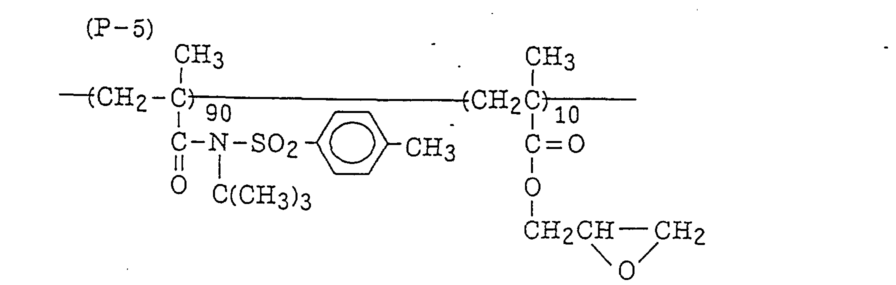

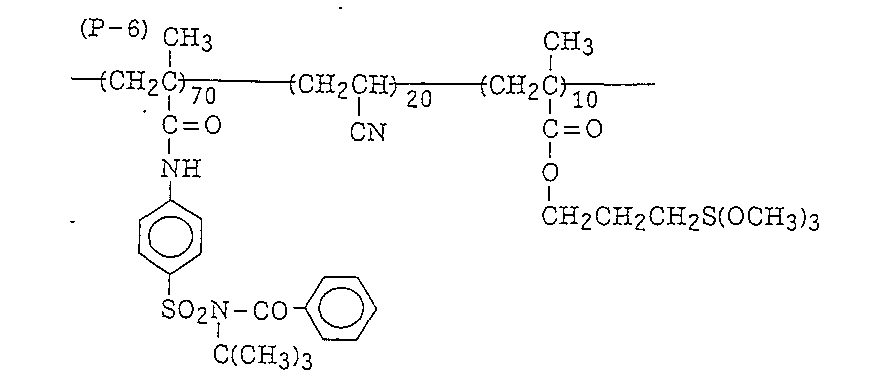

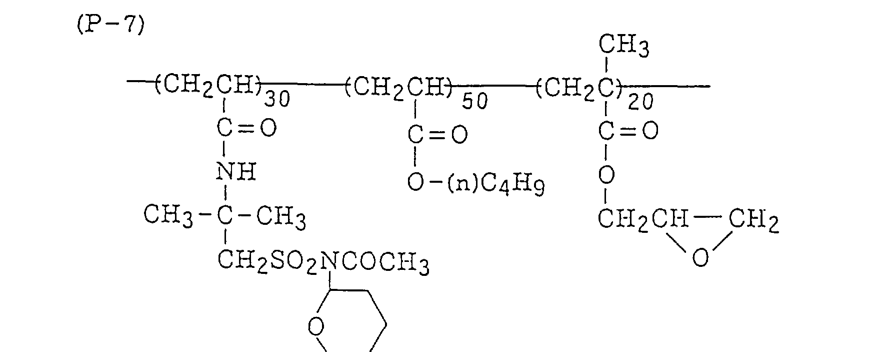

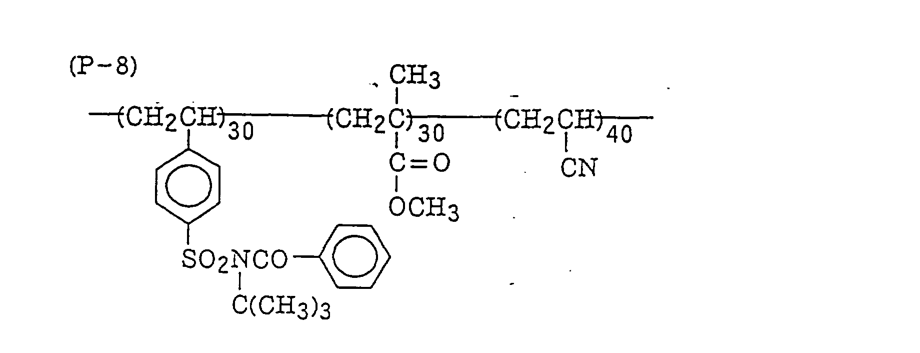

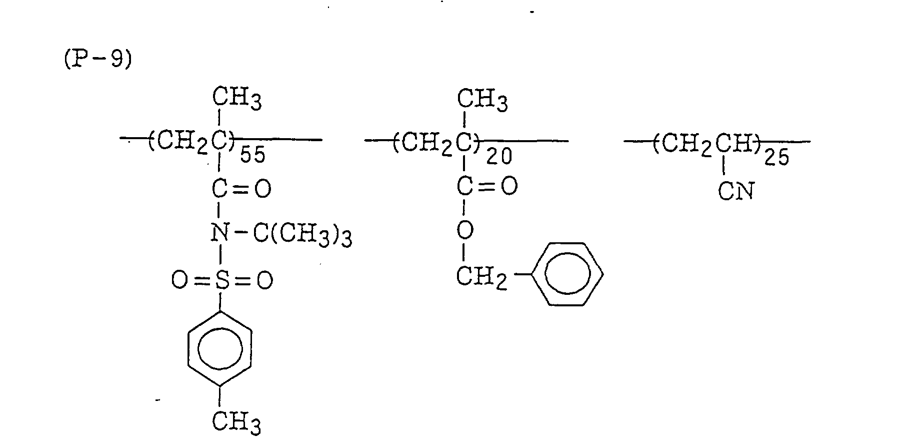

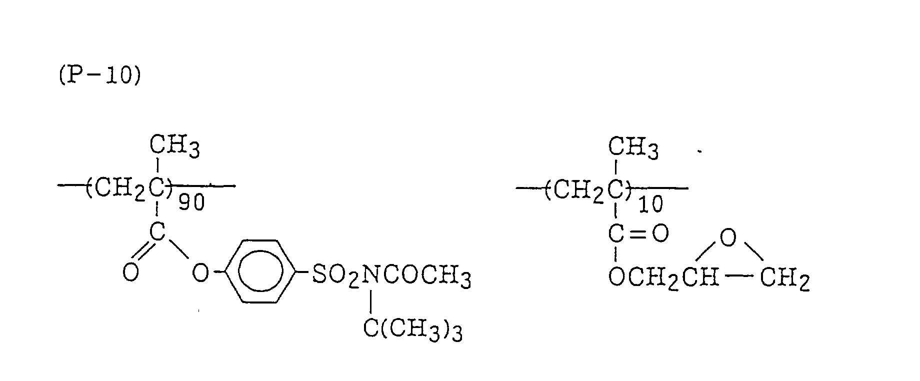

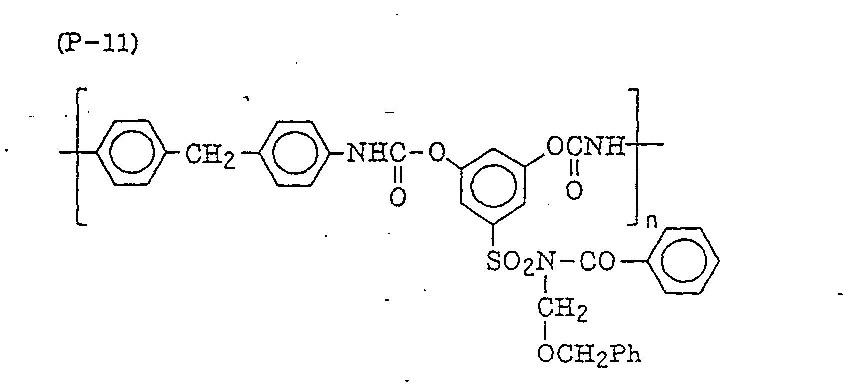

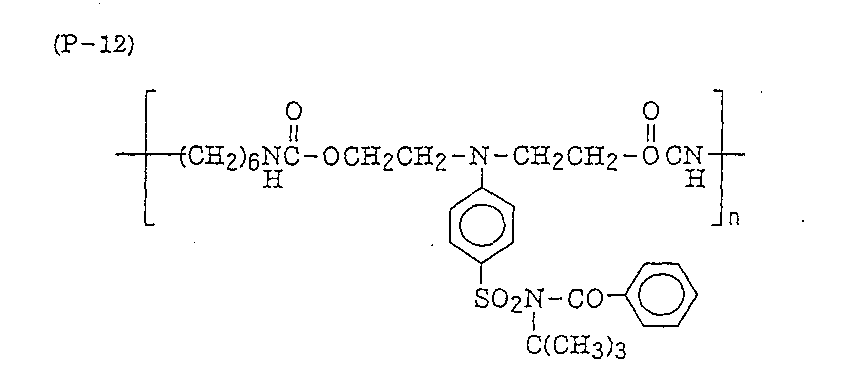

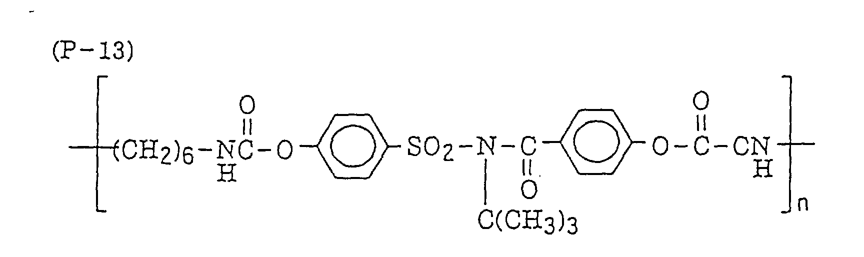

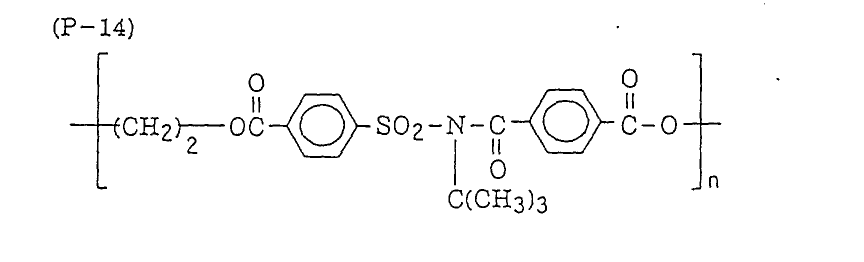

Synthesis Examples of polymers having N-sulfonylamide groups according to the present invention are described below.

### Synthesis of Monomer (Exemplified Compound M-2):

In a 1-liter three necked flask were placed 30.0 g of N-t-butyl-p-toluenesulfonamide, 17.4 g of triethylamine, 2.0 g of dimethylaminopyridine and 300 ml of acetonitrile.

The flask was cooled in an ice bath, and 18.0 g of methacryl chloride was dropped thereinto over a one-hour period with stirring.

After the dropping, the stirring was continued for 3 hours at room temperature, and allowed to stand overnight.

Then, the resulting solution was poured into 800 ml of water, extracted with 500 ml of ethyl acetate, dried over magnesium sulfate, and then concentrated. The concentrate obtained was recrystallized from a 3:1, by volume, mixture of hexane and ethyl acetate. Thus, 23 g of white crystals having the melting point of 64°C were obtained.

### Synthesis Example B-1

### Synthesis of Polymer having N-Sulfonylamido Groups (P-4):

In a 100-ml three necked flask, 7.2 g of Compound M-2, 1.0 g of methacryloxypropyltrimethoxysilane and 16 g of ethyl acetate were placed, and kept at 65°C with stirring under a stream of nitrogen. Thereto, 7.8 mg of 2,2'-azobis(2,4-dimethylvaleronitrile) was added, and the stirring was continued. After a lapse of two hours, 20.0 mg of 2,2'-azobis(2,4-dimethylvaleronitrile) was further added, and subjected to 4-hour stirring. Then, the reaction solution was cooled to room temperature, and poured into 500 ml of methanol. A solid precipitate (polymer) was filtered off, and dried. The weight-average molecular weight of the polymer determined by GPC was 3.6×10⁴. Yield: 6.1 g.

### Synthesis Example B-2

### Synthesis of Polymer containing N-Sulfonylamido Groups (P-5):

In a 100-ml three necked flask, 8.0 g of Compound M-2, 0.43 g of glycidyl methacrylate and 16 g of ethyl acetate were placed, and kept at 65°C with stirring under a stream of nitrogen. Thereto, 5.8 mg of 2,2'-azobis(2,4-dimethylvaleronitrile) was added, and the stirring was continued. After a lapse of two hours, 15.0 mg of 2,2'-azobis(2,4-dimethylvaleronitrile) was further added, and subjected to 4-hour stirring. Then, the reaction solution was cooled to room temperature, and poured into 500 ml of methanol. A solid precipitate (polymer) was filtered off, and dried. The weight-average molecular weight of the polymer determined by GPC was 4.3×10⁴. Yield: 5.6 g.

Those polymers having the constitutional units of formula (III) are used in a proportion of generally from 5 to 99 weight %, preferably from 10 to 99 weight %, more preferably from 15 to 98 weight %, to the total ingredients of the composition (excepting a coating solvent).

With respect to the compound which is decomposed by undergoing the action of light or heat to generate an acid (abbreviated as a photoacid generator, hereinafter), a compound selected properly from among a photoinitiator for photo cationic polymerization, a photoinitiator for photo radical polymerization, a photodecolorizer for dyes, a photo discoloring agent, known photoacid-producing compounds used for microresist and the like, arid a mixture of two or more of the above agents can be used in the present invention.

As examples of compounds employable as those agents, mention may be made of the diazonium salts described, e.g., in S.I. Schlesinger, Photogr. Sci. Eng., 18, 387 (1974), and T.S. Bal et al., Polymer, 21, 423 (1980); onium salts, such as the ammonium salts described, e.g., in U.S. Patents 4,069,055, 4,069,056 and Re 27,992, and JP-A-3-140140, the phosphonium salts described, e.g., in D.C. Necker et al., Macromolecules, 17, 2468 (1984), C.S. Wen et al., Teh. Proc. Conf. Rad. Curing ASIA, p. 478, Tokyo (Oct., 1988), and U.S. Patents 4,069,055 and 4,069,056, the iodonium salts described, e.g., in J.V. Crivello et al., Macromolecules, 10(6), 1307 (1977), Chem. & Eng. News, Nov. 28, p. 31 (1988), European Patent 0,104,143, U.S. Patents 339,049 and 410,201, JP-A-2-150848 and JP-A-2-296514, the sulfonium salts described, e.g., in J.V. Crivello et al., Polymer J., 17, 73 (1985), J.V. Crivello et al., J. Org. Chem., 43, 3055 (1978), W.R. Watt et al., J. Polymer Sci., Polymer Chem. Ed., 22, 1789 (1984), J.V. Crivello et al., Polymer Bull., 14, 279 (1985), J.V. Crivello et al., Macromolecules, 14(5), 1141 (1981), J.V. Crivello et al., J. Polymer Sci., Polymer Chem. Ed., 17, 2877 (1979), European Patent 0,370,693, U.S. Patent 3,902,114, European Patents 0,233,567, 0,297,443 and 0,297,442, U.S. Patents 4,933,377, 4,837,124, 4,760,013, 4,734,444 and 2,833,827, and German Patents 2,904,626, 3,604,580 and 3,604,581, the selenonium salts described, e.g., in J.V. Crivello et al., Macromolecules, 10(6), 1307 (1977), and J.V. Crivello et al., J. Polymer Sci., Polymer Chem. Ed., 17, 1047 (1979), and the arsonium salts described, e.g., in C.S. Wen et al., Teh. Proc. Conf. Rad. Curing ASIA, p. 478, Tokyo (Oct., 1988); the organic halogeno-compounds described, e.g., in U.S. Patent 3,905,815, JP-B-46-4605 (The term "JP-B" as used herein means an "examined Japanese patent publication"), JP-A-48-36281, JP-A-55-32070, JP-A-60-239736, JP-A-61-169835, JP-A-61-169837, JP-A-62-58241, JP-A-62-212401, JP-A-63-70243 and JP-A-63-298339; the organometallic compounds/organic halides described, e.g., in K. Meier et al., J. Rad. Curing, 13(4), 26 (1986), T.P. Gill et al., Inorg. Chem., 19, 3007 (1980), D. Astruc, Acc. Chem. Res., 19(12), 377 (1896), and JP-A-2-161445; the photoacid generators having o-nitrobenzyl type protective groups described, e.g., in S. Hayase et al., J. Polymer Sci., 25, 753 (1987), E. Reichmanis et al., J. Polymer Sci., Polymer Chem. Ed., 23, 1 (1985), Q.Q. Zhu et al., J. Photochem., 36, 85, 39, 317 (1987), B. Amit et al., Tetrahedron Lett., (24) 2205 (1973), D.H.R. Barton et al., J. Chem. Soc., 3571 (1965), P.M. Collins et al., J. Chem. Soc., Perkin I, 1695 (1975), M. Rudinstein et al., Tetrahedron Lett., (17), 1445 (1975), J.W. Walker et al., J. Am. Chem. Soc., 110, 7170 (1988), S.C. Busman et al., J. Imaging Technol., 11(4), 191 (1985), H.M. Houlihan et al., Macromolecules, 21, 2001 (1988), P.M. Collins et al., J. Chem. Soc., Chem. Commun., 532 (1972), S. Hayase et al., Macromolecules, 18, 1799 (1985), E. Reichmanis et al., J. Electrochem. Soc., Solid State Sci. Technol., 130(6), F.M. Houlihan et al., Macromolecules, 21, 2001 (1988), European Patents 0,290,750, 0,046,083, 0,156,535, 0,271,851 and 0,388,343, U.S. Patents 3,901,710 and 4,181,531, JP-A-60-198538 and JP-A-53-133022; the compounds generating sulfonic acid through photolysis represented by iminosulfonates and the like as described in M. Tunooka et al., Polymer Preprints Japan, 35(8), G. Berner et al., J. Rad. Curing, 13(4), W.J. Mijis et al., Coating Technol., 55(697), 45 (1983), Akzo, H. Adachi et al., Polymer Preprints Japan, 37(3), European Patents 0,199,672, 0,084,515, 0,199,672, 0,044,115 and 0,101,122, U.S. Patents 4,618,564, 4,371,605 and 4,431,774, JP-A-64-18143, JP-A-2-245756, and JP-A-4-365048; and the disulfone compounds described, e.g., in JP-A-61-166544.

In addition, the polymers having main or side chains into which groups or compounds capable of generating acids upon exposure to light are introduced, such as the compounds described, e.g., in M.E. Woodhouse et al., J. Am. Chem. Soc., 104, 5586 (1982), S.P. Pappas et al., J. Imaging Sci., 30(5), 218 (1986), S. Kondo et al., Makromol. Chem., Rapid Commun., 9, 625 (1988), Y. Yamada et al., Makromol. Chem., 152, 153, 163 (1972), J.V. Crivello et al., J. Polymer Sci., Polymer Chem. Ed., 17, 3845 (1979), U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, can be employed.

Further, the compounds capable of generating acids upon exposure to light described, e.g., in V.N.R. Pillai, Synthesis, (1), 1 (1980), A. Abad et al., Tetrahedron Lett., (47) 4555 (1971), D.H.R. Barton et al., J. Chem. Soc., (C), 329 (1970), U.S. Patent 3,779,778 and European Patent 0,126,712, can be employed, too.

Of the compounds recited above as those which generate acids by undergoing the action of light or heat, the following compounds are used to particular advantage:
(1) A trihalomethyl-substituted oxazole compound of the following formula (PAG1), or a trihalomethyl-substituted s-triazine compound of the following formula (PAG2); 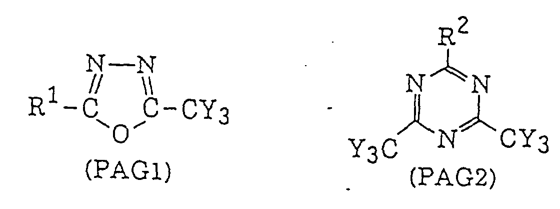 wherein R¹ is a substituted or unsubstituted aryl or alkenyl group, R² is a substituted or unsubstituted aryl, alkenyl or alkyl group or -C(Y)₃, and Y is a chlorine or bromine atom.
   Specific examples of such compounds are illustrated below, but these examples should not be construed as limiting the scope of the present invention. 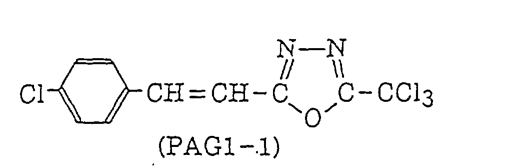 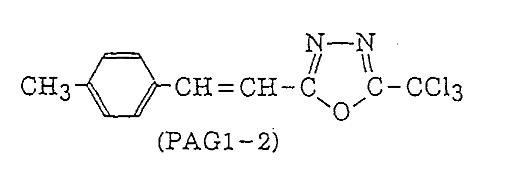 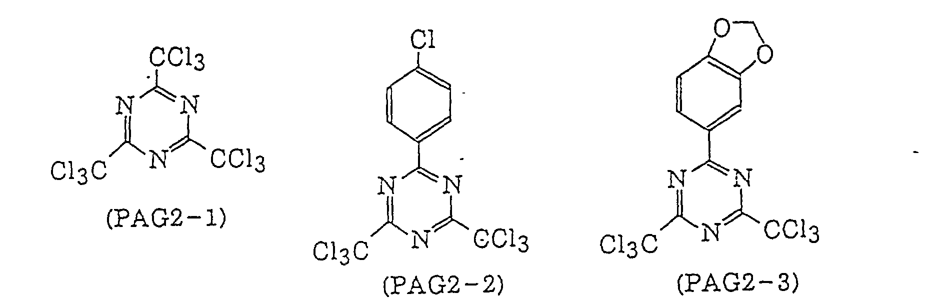 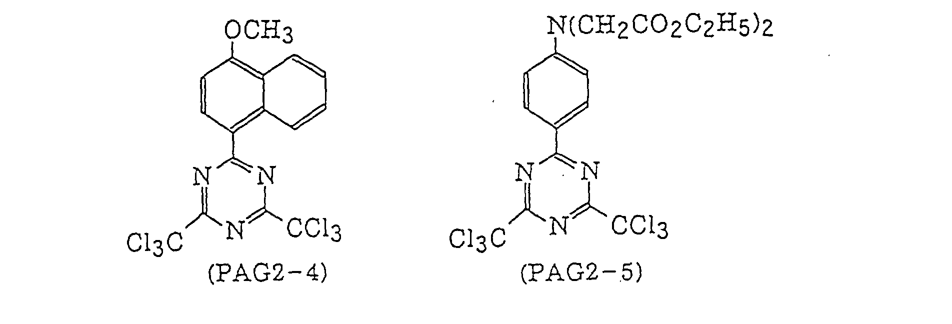
(2) An iodonium salt of the following formula (PAG3), a sulfonium salt of the following formula (PAG4), or a diazonium salt: 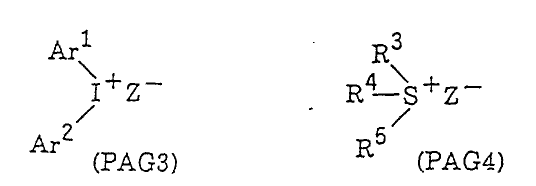 wherein Ar¹ and Ar² are each a substituted or unsubstituted aryl group. Examples of a substituent suitable for the aryl group include an alkyl group, a haloalkyl group, a cycloalkyl group, an aryl group, an alkoxy group, a nitro group, a carboxyl group, an alkoxycarbonyl group, a hydroxy group, a mercapto group and a halogen atom.
   R³, R⁴ and R⁵ are each a substituted or unsubstituted alkyl or aryl group. Preferably, each of them is a 6-14C aryl group, a 1-8C alkyl group or a substituted derivative thereof. Examples of a substituent suitable for the aryl group include a 1-8C alkoxy group, a 1-8C alkyl group, a nitro group, a carboxyl group, a hydroxy group and a halogen atom, and those for the alkyl group include a 1-8C alkoxy group, a carboxyl group and an alkoxycarbonyl group.
   Z⁻ is a counter anion, such as BF₄⁻, AsF₆⁻, PE₆⁻, SbF₆⁻, SiF₆²⁻, ClO₄⁻, a perfluoroalkanesulfonic acid anion such as CF₃SO₃⁻, a pentafluorobenzenesulfonic acid anion, a condensed polynuclear aromatic sulfonic acid anion such as naphthalene-1-sulfonic acid anion, an anthraquinonesulfonic acid anion, or a dye containing sulfonic acid group. However, the counter ion as Z⁻ should not be construed as being limited to the above-recited ones.
   Further, two among R³, R⁴ and R⁵, and two of Ar¹ and Ar² as well, may combine with each other via a single bond or a substituent.
   Specific examples of such compounds are illustrated below, but these examples should not be construed as limiting the scope of the present invention. 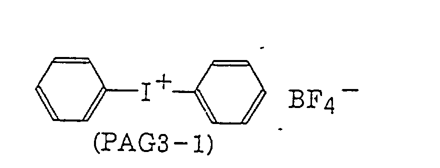 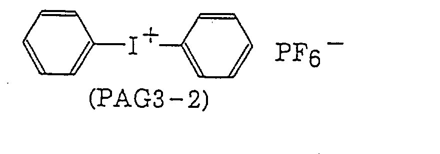 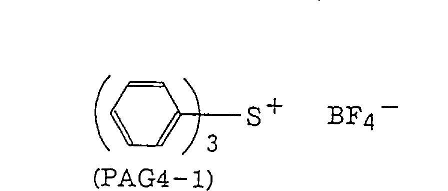 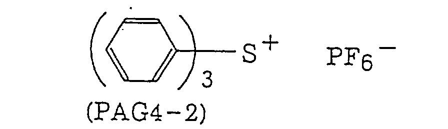 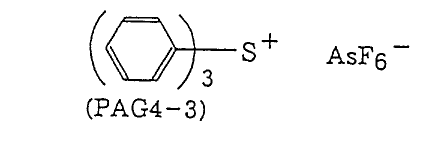
   The above-illustrated onium salts of formulae (PAG3) and (PAG4) are known compounds, and can be prepared using the methods described, e.g., in J.W. Knapczyk et al., J. Am. Chem. Soc., 91, 145 (1969), A.L. Maycok et al., J. Org. Chem., 35, 2532 (1970), E. Goethas et al., Bull. Soc. Chem. Belg., 73, 546 (1964), H.M. Leicester, J. Am. Chem. Soc., 51, 3587 (1929), J.V. Crivello et al., J. Polym., Polymer Chem. Ed., 18, 2677 (1980), U.S. Patents 2,807,648 and 4,247,473, and JP-A-53-101331.
(3) A disulfone compound represented by the following formula (PAG5) or an iminosulfonate compound represented by the following formula (PAG6): 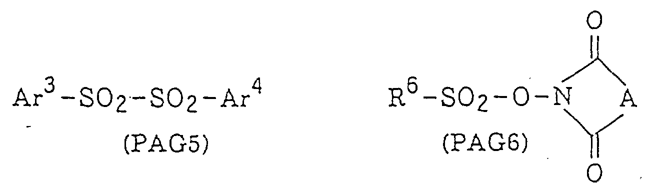 wherein Ar³ and Ar⁴ are each a substituted or unsubstituted aryl group, R⁶ is a substituted or unsubstituted alkyl or aryl group, and A is a substituted or unsubstituted alkylene, alkenylene or arylene group.

Specific examples of such compounds are illustrated below, but these examples should not be construed as limiting the scope of the present invention.

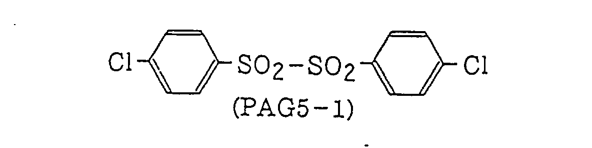

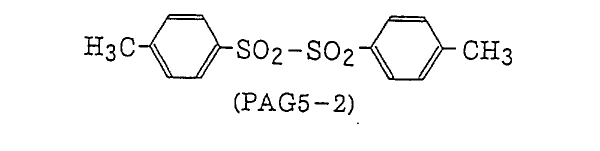

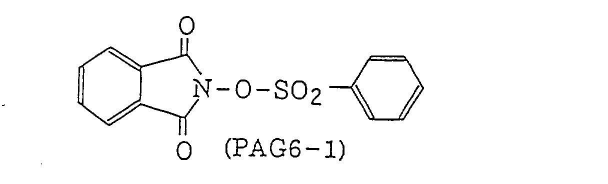

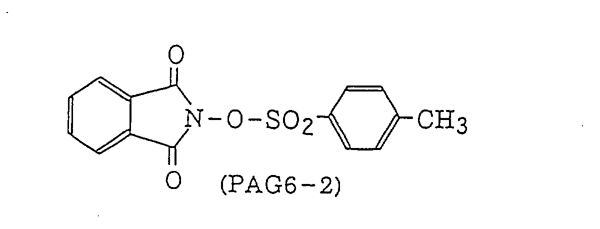

The foregoing compounds which are decomposed by the action of light or heat thereon to generate acids are used in the proportion of from 0.001 to 40 weight %, preferably from 0.01 to 20 weight %, and more preferably from 0.1 to 5 weight %,
based on the total weight of the composition (excluding a coating solvent).

Further, the spectral sensitizers as recited below are added to induce sensitivity to the wavelengths at which the photoacid generator used has no spectral absorption, that is, wavelengths longer than far ultraviolet region, and thereby it becomes possible to confer the sensitivity to i-or g-line upon the present photosensitive composition. Specific examples of such a spectral sensitizer include benzophenone, p,p'-tetramethyldiaminobenzophenone, p,p'-tetraethylethylaminobenzophenone, 2-chlorothioxanthone, anthrone, 9-ethoxyanthracene, anthracene, pyrene, perylene, phenothiazine, benzil, Acridine Orange, benzoflavin, Cetoflavin-T, 9,10-diphenylanthracene, 9-fluorenone, acetophenone, phenanthrene, 2-nitrofluorene, 5-nitroacenaphthene, benzoquinone, 2-chloro-4-nitroaniline, N-acetyl-p-nitroaniline, p-nitroaniline, N-acetyl-4-nitro-1-naphthylamine, picramide, anthraquinone, 2-ethylanthraquinone, 2-tert-butylanthraquinone, 1,2-benzanthraquinone, 3-methyl-1,3-diaza-1,9-benzanthrone, dibenzalacetone, 1,2-naphthoquinone, 3,3'-carbonyl-bis(5,7-dimethoxycarbonylcoumarin) and coronene, but these examples should not be construed as limiting on the scope of spectral sensitizers usable in the invention.

For the purpose of conferring the sensitivity to light of wavelengths in the visible region upon the present composition, known spectral sensitizers such as cyanine dyes, merocyanine dyes, squarylium dyes, coumarin dyes, xanthene dyes, Julolidine dyes, pyrylium dyes, acridine dyes, Michler's ketone, thioxanthone and acridone can be used.

Besides the above-recited spectral sensitizers, dyes exhibiting their absorption in the infrared region are used to advantage, especially in preparing a photosensitive composition for an infrared-sensitive lithographic plate, because they enable the production of acids under the action of infrared rays when they are used in combination with the photoacid generators illustrated above.

With respect to infrared-absorbing dyes or pigments used for the foregoing purpose, the dyes or pigments capable. of effectively absorbing infrared rays of wavelengths of from 760 nm to 1,200 nm are examples thereof. Preferably, the dyes or pigments used are those having their absorption maxima in the wavelength region of 760 to 1,200 nm.

As for such dyes, the commercially available dyes and the dyes known in the literature, e.g., Senryo Binran (the meaning of this title is "Handbook of Dyes"), compiled by Yuki Gosei Kagaku Kyokai in 1970, can be used. Specifically, azo dyes, metal complex azo dyes, pyrazolone azo dyes, anthraquinone dyes, phthalocyanine dyes, carbonium dyes, quinoneimine dyes, methine dyes, cyanine dyes, metal thiolate complexes and the like are employable.

Of those dyes, the cyanine dyes described, e.g., in JP-A-58-125246, JP-A-59-84356, JP-A-59-202829 and JP-A-60-78787, the methine dyes described, e.g., in JP-A-58-173696, JP-A-58-181690 and JP-A-58-194595, the naphthoquinone dyes described, e.g., in JP-A-58-112793, JP-A-58-224793, JP-A-59-48187, JP-A-59-73996, JP-A-60-52940 and JP-A-60-63744, the squarylium dyes described, e.g., in JP-A-58-112792 and the cyanine dyes described in British Patent 434,875 are preferably utilized.

Also, the near infrared absorbing sensitizers described in U.S. Patent 5,156,938 can be used to advantage. Further, the substituted arylbenzo(thio)pyrylium salts described in U.S. Patent 3,881,924, the trimethinethiapyrylium salts described in JP-A-57-142645 (corresponding to U.S. Patent 4,327,169), the pyrylium compounds described in JP-A-58-181051, JP-A-58-220143, JP-A-59-41363, JP-A-59-84248, JP-A-59-84249, JP-A-59-146063 and JP-A-59-146061, the cyanine dyes described in JP-A-59-216146, the pentamethinethiopyrylium salts described in U.S. Patent 4,283,475 and the pyrylium compounds disclosed in JP-B-5-13514 and JP-B-5-19702 are preferably used, too.

As other examples of dyes of the foregoing type, mention may be made of the near infrared absorbing dyes represented by formulae (I) and (II) disclosed in U.S. Patent 4,756,993.

Of those dyes, the cyanine dyes, the squarylium dyes, the pyrylium salts and the nickel thiolate complexes are preferred in particular.

As for suitable dyes, oil colors and basic dyes are examples thereof. Specifically, Oil Yellow #101, Oil Yellow #103, Oil Pink #312, Oil Green BG, Oil Blue BOS, Oil Blue #603, Oil Black BY, Oil Black BS, Oil Black T-505 (which are products of Orient Kagaku Kogyo Co., Ltd.), Crystal Violet (CI42555), Methyl Violet (CI42535), Rhodamine B (CI45170B), Malachite Green (CI42000) and Methylene Blue (CI52015) can be used to advantage.

The pigments which can be used in the present invention include the commercially available pigments and the pigments described in the literature, e.g., Color Index (C.I.) Handbook, Saishin Ganryo Binran (the meaning of this title is "Handbook of The Latest Pigments"), compiled by Nippon Ganryo Gijutsu Kyokai in 1977, Saishin Ganryo Oyo Gi jutsu (the meaning of this title is "The Latest Application Arts of Pigments"), published by CMC Shuppan in 1986, and Insatsu Ink Gijutsu (the meaning of this title is "Arts of Printing Ink"), published by CMC Shuppan in 1984.

As for the kinds of usable pigments, black pigments, yellow pigments, orange pigments, brown pigments, red pigments, violet pigments, blue pigments, green pigments, fluorescent pigments, metallic powder pigments and polymer-bonded dyes can be instanced. More specifically, insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments and carbon black can be used. Of these pigments, carbon black is preferred over the others.

Those pigments may be used without undergoing any surface treatment, or may be subjected to a surface treatment before use. As a method for the surface treatment, a method of coating the pigment surface with a resin or wax, a method of making a surfactant adhere to the pigment surface or a method of binding a reactive substance (e.g., a silane coupling agent, an epoxy compound, a polyisocyanate) to the pigment surface can be adopted. These methods for surface treatment are described, e.g., in Kinzoku Sekken no Seishitsu to Oyo (the meaning of this title is "Properties and Applications of Metal Soap"), published by Saiwai Shobo, the book cited above, entitled "Insatsu Ink Gijutsu", published by CMC Shuppan in 1984, and the book cited above, entitled "Saishin Ganryo Oyo Gijutsu", published by CMC Shuppan in 1986.

The size of pigment particles is preferably from 0.01 to 10 µm, and more preferably from 0.05 to 1 µm. In particular, the size ranging from 0.1 to 1 µm is advantageous to the pigment particles. In view of the stability of pigment dispersion in a coating composition for a photosensitive layer, it is undesirable for the pigment to have a particle size smaller than 0.01 µm; while the particle sizes greater than 10 µm are undesirable from the viewpoint of uniformity in the image recording layer.

The pigment dispersion can be prepared using known dispersion techniques for producing ink, toner and the like. As for the dispersing machines used therein, an ultrasonic disperser, a sand mill, an attrition mill, a pearl mill, a super mill, a ball mill, an impeller, a disperser, a KD mill, a colloid mill, a Dynatron, a three-rod roll mill and a pressure kneader are examples thereof. For details of dispersion techniques the above-cited book entitled "Saishin Ganryo Oyo Gijutsu" (published by CMC Shuppan in 1986) can be referred to.

The dyes or pigments as recited above can be added to the present composition in a proportion of from 0.01 to 50 weight %, preferably from 0.1 to 10 weight %, particularly preferably from 0.5 to 10 weight % in the case of dyes and from 3.1 to 10 weight % in the case of pigments, to the total solids in the composition. When the proportion of dyes or pigments in the composition is less than 0.01 weight %, sufficient sensitivity cannot be achieved; while the addition thereof in a proportion greater than 50 weight % causes scumming in non-image areas upon printing.

Those dyes or pigments may be incorporated in the same layer as other ingredients, or in a layer provided separately from the layer containing other ingredients.

With respect to a high molecular organic binder usable in the present composition, organic binders which are insoluble in water but soluble or at least swellable in an alkaline aqueous solution (so that they may be called alkali-soluble resins) are examples thereof. More specifically, a novolak resin, a hydrogenated novolak resin, an acetone-pyrogallol resin, a poly(hydroxystyrene), a halogen- or alkyl-substituted poly(hydroxystyrene), a hydroxystyrene-N-substituted maleinimide copolymer, a partially O-alkylated or O-acylated poly(hydroxystyrene), a styrene-maleic anhydride copolymer, a carboxyl group-containing methacrylic resin and derivatives thereof can be used in the present invention, but these resins should not be construed as limiting the scope of the invention in any way.

Of those alkali-soluble resins, a novolak resin and a poly(hydroxystyrene) are preferred in particular. The novolak resin can be obtained using specified monomers as main component and subjecting them to the addition condensation reaction with aldehydes in the presence of an acidic catalyst.

As for the specified monomers, aromatic hydroxy compounds, such as phenol, cresols (e.g., m-cresol, p-cresol and o-cresol), xylenols (e.g., 2,5-xylenol, 3,5-xylenol, 3,4-xylenol and 2,3-xylenol), alkylphenols (e.g., m-ethylphenol, p-ethylphenol, o-ethylphenol, p-t-butylphenol, p-octylphenol and 2,3,5-trimethylphenol), alkoxyphenols (e.g., p-methoxyphenol, m-methoxyphenol, 3,5-dimethoxyphenol, 2-methoxy-4-methylphenol, m-ethoxyphenol, p-ethoxyphenol, m-propoxyphenol, p-propoxyphenol, m-butoxyphenol and p-butoxyphenol), bisalkylphenols (e.g., 2-methyl-4-isopropylphenol), m-chlorophenol, p-chlorophenol, o-chlorophenol, dihydroxybiphenyl, bisphenol A, phenylphenol, resorcinol and naphthol, can be employed alone or as a mixture of two or more thereof. However, these examples should not be considered as limiting on the scope of the invention.

Specific examples of aldehydes which can be used include formaldehyde, paraformaldehyde, acetaldehyde, propionaldehyde, benzaldehyde, phenylacetaldehyde, α-phenylpropyl aldehyde, β-phenylpropyl aldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, furfural, chloroacetaldehyde, and acetal compounds thereof such as chloroacetaldehyde diethylacetal. Of these aldehydes, formaldehyde is used to particular advantage.

Those aldehydes can be used alone or as a mixture of two or more thereof. As for the acidic catalyst which can be used, hydrochloric acid, sulfuric acid, formic acid, acetic acid and oxalic acid are examples thereof.

It is desirable for the novolak resins obtained in the foregoing manner to have their weight-average molecular weight in the range of 1,000 to 30,000. When the weight average molecular weight is below 1,000, a decrease of film thickness due to development is too great in the unexposed area; while, when it is increased beyond 30,000, the development speed becomes low. The weight-average molecular weight particularly suitable for the novolak resins is from 2,000 to 20,000.

Additionally, the weight-average molecular weight is defined as the value determined by gel permeation chromatography on a polystyrene basis.

Those alkali-soluble resins as recited above may be used as a mixture of two or more thereof. The proportion of alkali-soluble resins to the total ingredients (excluding a solvent) in the present composition is from 0 to 97 % by weight, preferably from 60 to 90 % by weight.

To the present composition, a high molecular organic binder can be added, if needed. As for the high molecular organic binder, although any of known polymers may be used, polyacrylate, polymethacrylate, polyacrylamide, polystyrene, polyester, polyurethane, a phenol resin, a novolak resin, a poly(hydroxystyrene) and an epoxy resin are especially suitable.

Of those high molecular organic binders, polymers insoluble in water but soluble or at least swellable in an aqueous alkali solution are useful in cases where the photosensitive materials according to the present invention are used for the image formation with an alkali developer. (which is also called an alkali-soluble resin). Specific examples of such a polymer include a novolak resin, an acetone-pyrogallol resin, a poly(hydroxystyrene), and a carboxyl-containing methacrylic resin and derivatives thereof.

These organic high molecular binders are used in a proportion of from 0 to 97 weight %, preferably from 0 to 90 weight %, to the total ingredients of the photosensitive composition (excluding a coating solvent).

The present N-sulfonylamide compounds which function as dissolution inhibitor can be used together with conventional dissolution inhibitors.

More specifically, besides the acid-cleavable sulfonamide compounds used in the present invention, the compounds having other linkages capable of being cleaved by an acid, such as C-O-C and C-O-Si linkages, may be used in combination.

As for conventional compounds having acid-cleavable C-O-C or C-O-Si linkages, compounds of the following types (a) to (i) are known to be effective:
(a) compounds which each contain at least one orthocarboxylic acid ester and/or carboxylic acid amide acetal group and have polymerizability to form polymers containing those groups as cross-linking elements in their main chain or as substituents in their side chains,
(b) olygomeric or polymeric compounds which each contain repeated acetal and/or ketal groups in their main chain,
(c) compounds which each contain at least one enol ether or N-acylaminocarbonate group,
(d) cyclic acetals or ketals of β-ketoesters or β-ketoamides,
(e) compounds containing silyl ether groups,
(f) compounds containing silyl enol ether groups,
(g) monoacetal or monoketal compounds whose acetal or ketone component has the solubility of from 0.1 to 100 g/ℓ in a developer,
(h) tertiary alcohol ethers, and
(i) carboxylic acid esters or carbonates of tertiary allylic or benzylic alcohols.

The acid-cleavable compounds of type (a) are described as a component of irradiation responsive mixtures in German Patent Application (OLS) Nos. 2,610,842 and 2,928,636. The mixtures containing the compounds of type (b) are described in German Patent 2,306,248 and 2,718,254. The compounds of type (c) are described in EP-A-0006626 and EP-A-0006627. The compounds of type (d) are described in EP-A-0202196, and the compounds of type (e) in German Patent Application (OLS) Nos. 3,554,165 and 3,601,264. The compounds of type (f) are described in German Patent Application (OLS) Nos. 3,730,785 and 3,730,783, and the compounds of type (g) in German Patent Application (OLS) No. 3,730,785. The compounds of type (h) are described, e.g., in U.S. Patent 4,603,101, and the compounds of type (i) are described, e.g., in U.S. Patent 4,491,628 and J.M. Frechet et al., J. Imaging Sci., vol. 30, pp. 59-64 (1986).

Also, the acid-cleavable compounds as described above can be used as a mixture of two or more thereof. Of the foregoing compounds of types (a) to (i), the compounds of the types (a), (b), (g) and (i) are preferred over the others. Of the compounds of type (b), polymerizing acetals are particularly noteworthy; while, of the acid-cleavable compounds of type (g), the compounds having an acetal or ketone component whose boiling point is higher than 150°C, preferably higher than 200°C, are worthy of remark. As other suitable examples of an acid-cleavable substance, mention may be made of organic polymers containing C-O-C or C-O-Si linkages. More specifically, those polymers include organic polymers containing acid-decomposable ether, ester, carbonate, acetal, ketal or silylether linkages. Specific examples of such polymers are described, e.g., in EP-A-0520265, U.S. Patent 4,985,332, West German Patent Nos. 2,718,254 and 3,601,264, and U.S. Patent 4,931,379.

The compounds containing acid-cleavable C-O-C or C-O-Si linkages are used in a proportion of 0 to 50 weight %, preferably 0 to 20 weight %, to the total ingredients of the photosensitive composition (excepting a solvent). When the compounds containing acid-cleavable C-O-C or C-O-Si linkages are polymers, they can be used in place of a part or all of the foregoing alkali-soluble resins.

The present photosensitive composition can further comprise other ingredients, such as a dye, a pigment, a plasticizer, a surfactant, a photosensitizer and a compound having at least two phenolic OH groups to promote dissolution in a developer, if needed.

In using the present composition in a coated state, a plate-form material having high dimensional stability is used as support. Specific examples of such a support include paper, plastic-laminated papers (e.g., papers laminated with polyethylene, polypropylene, polystyrene, etc.), plates of metals (e.g., aluminum (including aluminum alloys), zinc, copper), plastic films (e.g., films of cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and papers or plastic films having thereon laminated or deposited films of metals as cited above. Of these supports, an aluminum plate is used to particular advantage in making a presensitized lithographic plate, because it is very high in dimensional stability, and cheap as well. In addition, a complex sheet having an aluminum sheet on a polyethylene terephthalate film in a bonded state is also favorable.

In a case where the support has a metal surface, especially an aluminum surface, it is desirable that the support be subjected to a surface treatment, such as a graining treatment, a dipping treatment in an aqueous solution of sodium silicate, potassium fluorozirconate, a phosphate, etc., an anodic oxidation treatment or so on. As other suitable supports, all materials for constituting or producing a capacitor, a semiconductor, a multi-layer printed circuit or an integrated circuit can be employed. In particular, a thermally oxidized silicon material and/or an optionally doped aluminum-coated silicon material, and other substrates generally used in semiconductor arts, such as silicon nitride, gallium arsenide and indium phosphide, are used to advantage. In addition, substrates known in the arts of producing liquid crystal displays, such as glass and indium tin oxide, plates and foils of metals (e.g., aluminum, copper, zinc), double and triple metal foils, metal-deposited nonconductive sheets, optionally aluminum-coated SiO₂ materials, and paper are well suited for a support material. Those support materials may be subjected to a thermal pretreatment, a surface roughening treatment, an initial etching treatment or a chemical treatment to undergo improvements in desired characteristics, e.g., enhancement of hydrophilicity.

The present composition is prepared by dissolving the aforementioned ingredients in a proper solvent, and coated on a support as recited above. Suitable examples of a solvent used therein include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethylacetate, ethylene glycol monoethylether acetate, propylene glycol monomethyl ether, propylene glycol monomethylether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethyl sulfoxide, N-methylpyrrolidone and tetrahydrofuran. These solvents are used alone or as a mixture of two or more thereof. The concentration of the aforementioned ingredients (the total solids, including additives) in such a solvent is preferably adjusted to from 2 to 50 weight %.

Also, a surfactant can be added to the solvent as recited above. Specific examples of such a surfactant include nonionic surfactants, such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkyl aryl ethers (e.g., polyoxyethylene octyl phenol ether, polyoxyethylene nonyl phenol ether), polyoxyethylene-polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylenesorbitan fatty acid esters (e.g., polyoxyethylenesorbitan monolaurate, polyoxyethylenesorbitan monopalmitate, polyoxyethylenesorbitan monostearate, polyoxyethylenesorbitan trioleate, polyoxyethylenesorbitan tristearate), fluorine-containing surfactants, such as Eftop EF301, EF303 and EF352 (commercial names, products of Shin-Akita Kasei K.K.), Megafac F171, F173 and F177 (commercial names, products of Dai-Nippon Ink & Chemicals, Inc.), Florad FC430 and FC431 (commercial names, products of Sumitomo 3M Co., Ltd.), Asahiguard AG710, Surflon S-382, SC101, SC102, SC103, SC104, SC105 and SC106 (commercial names, products of Asahi Glass Company, Ltd.), organosiloxane polymers, such as KP341 (code name of Shin-etsu Chemical Co., Ltd.), and acrylic or methacrylic acid (co)polymers, such as Polyflow No. 75 and No. 95 (commercial names, products of Kyoeisha Yushi Kagaku Kogyo K.K.). The amount of those surfactants added is generally not greater than 2 parts by weight, preferably not greater than 1 part by weight, per 100 parts by weight of the total solids in the present composition. Those surfactants may be added alone or as a mixture of two or more thereof.

The photosensitive materials prepared from compositions according to the present invention, although can produce images without a developer, can ensure high sensitivity in the image formation with a developer as well; as a result, they can be used as chemical amplification type lithographic materials or resist materials. The alkali developer used for such a purpose is an alkaline aqueous solution containing an inorganic alkali such as sodium hydroxide, potassium hydroxide, sodium carbonate, sodium hydrogen carbonate, sodium silicate, potassium silicate, sodium metasilicate, sodium tertiary phosphate, sodium secondary phosphate, ammonium tertiary phosphate, ammonium secondary phosphate, sodium metasilicate or aqueous ammonia, a primary amine such as ethylamine or n-propylamine, a secondary amine such as diethylamine or di-n-butylamine, a tertiary amine such as triethylamine or methyldiethylamine, an alcohol amine such as dimethylethanolamine or triethanolamine, a quaternary ammonium salt such as tetramethylammonium hydroxide or tetraethylammonium hydroxide, or a cyclic amine such as pyrrole or piperidine. To such an alkaline aqueous solution, an alcohol such as benzyl alcohol and a surfactant can be added in appropriate amounts.

As examples of a light source of active beams used for the exposure of the present photosensitive composition, mention may be made of an ultra-high pressure, medium or low pressure mercury lamp, a metal halide lamp, a xenon lamp, a chemical lamp, a carbon arc lamp, various laser devices for visible, ultraviolet and other rays, a fluorescent lamp, a tungsten lamp and sun light. As for the radiations, electron beams, X-rays, ion beams and far ultraviolet rays are examples thereof. As a light source for photoresists, g-ray, i-ray and Deep-UV light are preferably used. Further, scanning or pulse exposure using high density energy beams (laser beams or electron beams) can also be employed for the exposure of the present composition. As for laser beams used for such exposure, He-Ne laser, argon laser, krypton ion laser, He-Cd laser and KrF excimer laser are examples thereof. For infrared radiation, on the other hand, solid laser or semiconductor laser devices capable of emitting infrared rays, particularly in the wavelength region of 760 to 1,200 nm, can be employed.

### EXAMPLES

The present invention will be illustrated below in more detail by the following examples, but the scope of the invention should not be construed as being limited by these examples. Additionally, in the following examples, all "%" are by weight unless otherwise indicated.

### EXAMPLES 1 TO 6 AND COMPARATIVE EXAMPLES 1 TO 4

The°surface of a 0.30 mm-thick aluminum plate was grained with a nylon brush and a water suspension of pumice powder of 400 mesh, and thoroughly washed with water. Then, the aluminum plate was etched by being dipped for 60 seconds in a 10 % sodium hydroxide solution kept at 70°C, followed by washing with running water. Further, the aluminum plate was washed with 20 % HNO₃ for neutralization, followed by washing with water. Furthermore, the electrolytic surface-roughening treatment of the aluminum plate was carried out in a 1 % water solution of nitric acid by furnishing anode electricity in a quantity of 160 coulomb/dm² using a sine-wave alternating waveform current under V_{A} = 12.7 V. The thus treated aluminum plate had the surface roughness of 0.6 µm (expressed in terms of Ra). Subsequently, the aluminum plate was desmutted by being dipped for 2 minutes in a 30 % water solution of sulfuric acid kept at 55°C, and further anodically oxidized in a 20 % water solution of sulfuric acid under the electric current density of 2 A/dm² so as to have a thickness of 2.7 g/m². On the thus prepared aluminum plate, each of the following photosensitive solutions was coated by means of a whirler, and dried for 2 minutes at 100°C.

| | |
|---|---|
| N-Sulfonylamide compound in Table 1 | 1.0 g |
| m/p-Cresol resin (m/p ratio: 6/4) | 2.0 g |
| p-(Phenylamino)benzenediazonium hexafluorophosphate | 0.5 g |
| Crystal Violet | 0.01 g |
| Methyl ethyl ketone | 18 g |
| 2-Methoxyethanol | 6 g |

The dry coverage of each photosensitive solution was 2.0 g/m². The thus obtained photosensitive lithographic printing-plates were each exposed to light for 1 minute using a metal halide lamp through a step tablet, Fuji Step Guide (made by Fuji Photo Film Co., Ltd., having 15 steps, an initial-step optical transmission density of 0.05 and an increase of 0.15 in optical transmission density every one-step increase). Each of the exposed plates was developed by one-minute dip in a 4 % water solution of sodium metasilicate. The thus processed plate was examined by visual observation as to whether or not the photosensitive layer thereof was eluted in the exposed area to form an image (image formability). In addition, the sensitivity was evaluated by the number of steps present in the image formed. The greater number of steps in an image obtained is an indication of the higher sensitivity. The results obtained are shown in Table 1. It can be seen from the results shown in Table 1 that the combinations of the present acid-decomposable compounds with a novolak resin afforded excellent positive-image formability and high sensitivity.

**Table 1**

| | Sulfonylamide Compound | Image Formability | Sensitivity |
|---|---|---|---|
| Example 1 | Compound 1 | clear image | 8 |
| Example 2 | Compound 2 | clear image | 7 |
| Example 3 | Compound 4 | clear image | 5 |
| Example 4 | Compound 5 | clear image | 6 |
| Example 5 | Compound 12 | clear image | 6 |
| Example 6 | Compound 14 | clear image | 9 |
| Comparative Example 1 | absent | no image (dissolved completely) | - |
| Comparative Example 2 | Compound A | no image (remaining entirely) | - |
| Comparative Example 3 | Compound B | no image (remaining entirely) | - |
| Comparative Example 4* | absent | clear image | 5 |

| | | | |
|---|---|---|---|
| * : Standard positive printing plate, VPS (made by Fuji Photo Film Co., Ltd.) | | | |

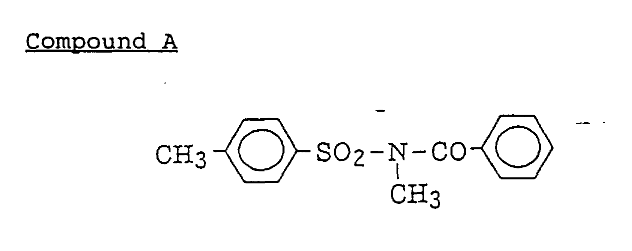

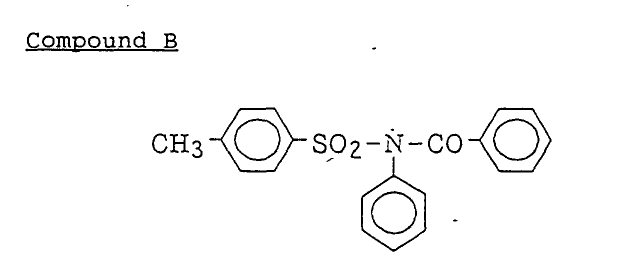

### EXAMPLES 7 TO 10

A 0.03 mm-thick aluminum plate (quality: 1050) was degreased with trichloroethylene, and the surface thereof was grained with a nylon brush and a water suspension of pumice powder of 400 mesh, and thoroughly washed with water. Then, the aluminum plate was etched by 9-second dipping in a 25 % sodium hydroxide solution kept at 45°C, followed by washing with water. Further, the plate was dipped for 20 seconds in 2 % HNO₃, and then washed with water. The thus etched amount at the grained surface was about 3 g/m². Furthermore, this plate was provided with 3 g/m² of an anodically oxidized film by using 7 % sulfuric acid as electrolyte under the condition of a D.C. current density of 15 A/dm², washed and then dried. The thus treated aluminum plate was coated with the subbing solution described below, and dried at 80°C for 30 seconds. The dry coverage of the subbing solution was 10 mg/m².

| | |
|---|---|
| β-Alanine | 0.1 g |
| Methanol | 40 g |
| Purified water | 60 g |

In the next place, four Solutions [A-1] to [A-4] were prepared so as to have the composition described below as Composition of Solution [A], wherein the compounds according to the present invention were different in sort from one another. Each of Solutions [A-1] to [A-4] was coated on the aluminum plate provided with the foregoing subbing layer, and dried at 100°C for 2 minutes. Thus, positive working lithographic plate materials [A-1] to [A-4] were obtained. Therein, the dry coverage was 1.7 g/m².

| | |
|---|---|
| Compound according to the invention (set forth in Table 2) | 1.0 g |
| 2,6-Bis(trichloromethyl)-4-(4-methoxy-1-naphthyl) -s-triazine (compound named PAG2-4 hereinbefore) | 0.2 g |
| Infrared absorbent NK-3508 (produced by Nippon Kanko Shikiso Kenkyusho K.K.) | 0.15 g |
| Novolak resin prepared from m/p-cresols and formaldehyde (m/p ratio: 8/2, weight-average molecular weight: 5,800) | 2.5 g |
| Dye (Victoria Pure Blue BOH having 1-naphthalene sulfonic acid ion as its counter ion) | 0.05 g |
| Megafac F-177 (fluorine-containing surfactant, produced by Dai-Nippon Ink & Chemicals, Inc.) | 0.06 g |
| Methyl ethyl ketone | 20 g |
| 2-Methoxyethanol | 7 g |

The compounds used in Solutions [A-1] to [A-4] are set forth in Table 2.

**Table 2**

| | Lithographic plate material | Compound used |
|---|---|---|
| Example 7 | [A-1] | Compound 5 |
| Example 8 | [A-2] | Compound 8 |
| Example 9 | [A-3] | Compound 11 |
| Example 10 | [A-4] | Compound 7 |

The thus obtained positive working lithographic plate materials [A-1] to [A-4] were kept for 5 days under a high temperature-high humidity condition, specifically under the condition of 35°C-75 RH. Then, they were each exposed by means of YAG laser emitting an infrared ray of 1064 nm. After the exposure, the plate materials underwent a one-minute heat treatment at 110°C, and then processed with an automatic developing machine wherein the developer DP-4 (1:8) and the rinsing solution FR-3 (1:7) (produced by Fuji Photo Film Co., Ltd.) was placed. Then, the plate surface was treated with the gum solution GU-7 (1:1) (produced by Fuji Photo Film Co., Ltd.), and subjected to printing operations with a press, Heidel KOR-D. The thus obtained prints were examined by visual observation as to whether or not scumming was generated on non-image areas. The observation results are shown in Table 3. The present plate materials gave satisfactory printed matters free from scumming on non-image areas.

**Table 3**

| | Lithographic plate material | Scum in non-image area upon printing |
|---|---|---|
| Example 7 | [A-1] | absent |
| Example 8 | [A-2] | absent |
| Example 9 | [A-3] | absent |
| Example 10 | [A-4] | absent |

### EXAMPLES 11 TO 18 AND COMPARATIVE EXAMPLES 5 TO 8

### Synthesis Example 1

### Synthesis of resin having acid-decomposable groups (Compound [B-1]):

Poly(p-hydroxystyrene) (weight-average molecular weight: 9,600) in an amount of 9 g was dissolved in 100 ml of dimethoxyethane, and thereto 12.6 g of 3,4-dihydro-2H-pyran and 0.5 ml of sulfuric acid were added. This solution was stirred for 15 hours at 30-40°C. After the reaction was completed, the reaction solution was concentrated under reduced pressure. The residue obtained was neutralized with sodium carbonate, and then poured into water to precipitate crystals. The crystals were filtered off, washed with water and dried under reduced pressure. Thus, 11.0 g of poly(p-tetrahydropyranyloxystyrene-p-hydroxystyrene) was obtained as white powder. The ratio of the p-tetrahydropyranyloxystyrene units to the p-hydroxystyrene units in the polymer obtained was determined to be 3:7 by ¹H-NMR analysis.

### Synthesis Example 2

### Synthesis of resin having acid-decomposable groups (Compound [B-2]):

In an atmosphere of nitrogen, 22 g of the p-t-butoxycarbonyloxystyrene prepared in accordance with the method described in U.S. Patent 4,491,628 was polymerized in toluene at 90°C for 5 hours in the presence of 2,2'-azobis(2,4-dimethylvaleronitrile) catalyst. After cooling, the reaction solution was poured into methanol to deposit crystals. The crystals deposited was filtered off, washed with methanol, and dried under reduced pressure. Thus, 15 g of poly(p-tert-butoxycarbonyloxystyrene) was obtained as white powder. A 7 g portion of this powder was dissolved in 1,4-dioxane, and thereto 10 ml of conc. hydrochloric acid was added. This solution was refluxed with stirring for 2.5 hours. After cooling, the reaction solution was poured into water to deposit crystals. The thus deposited crystals was filtered off, washed with water, and dried under reduced pressure to yield 4 g of poly(p-tert-butoxycarbonyloxystyrene-p-hydroxystyrene) as white powder. The ratio of the p-tert-butoxycarbonyloxystyrene units to the p-hydroxystyrene units in the polymer obtained was determined to be 1:9 by ¹H-NMR analysis.

### Synthesis Example 3

### Synthesis of resin having acid-decomposable groups (Compound [B-3]):

Poly(p-hydroxystyrene) (weight-average molecular weight: 9,600) in an amount of 12 g was dissolved in 120 ml of N,N-dimethylacetamide, and thereto 7 g of potassium carbonate and 9 g of t-butyl bromoacetate were added successively, followed by 7-hour stirring at 120°C. The reaction solution was treated in the same manner as that for the synthesis of Compound [B-2] to yield a resin having the following structure. The ratio of the acid-decomposable group-containing units to the p-hydroxystyrene units in the resin was determined to be 1:6 by ¹H-NMR analysis.

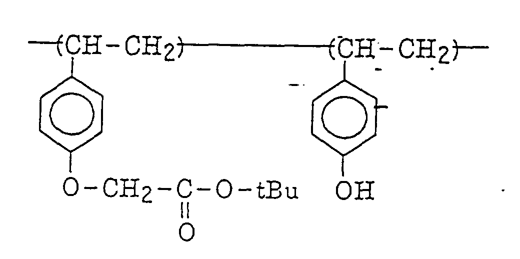

### Synthesis Example 4

### Synthesis of Dissolution Inhibitor (Compound [IN-1]):

1-[α-methyl-α-(4'-hydroxyphenyl)ethyl]-4-[α',α'-bis(4"-hydroxyphenyl)ethyl]benzene in an amount of 42.4 g (0.10 mole) was dissolved in 300 ml of N,N-dimethylacetamide, and thereto 49.5 g (0.35 mole) of potassium carbonate and 84.8 g (0.33 mole ) of cumyl bromoacetate were added. The resulting solution was stirred for 7 hours at 120°C. The reaction mixture obtained was poured into 2 liter of ion exchanged water, neutralized with acetic acid, and then extracted with ethyl acetate. The extract obtained was concentrated, and purified by column chromatography (carrier: silica gel, developing solvent: ethyl acetate/n-hexane (3/7 by volume) mixture). Thus, 70 g of the following compound (all R groups were -CH₂COOC(CH₃)₂C₆H₅) was obtained.

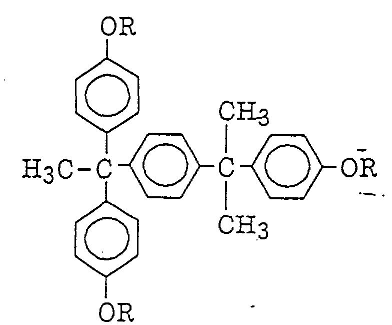

### Synthesis Example 5

### Synthesis of Dissolution Inhibitor (Compound [IN-2]):

α,α,α',α',α",α"-hexakis(4-hydroxyphenyl)-1,3,5-triethylbenzene in an amount of 14.3 g (0.020 mole) was dissolved in 120 ml of N,N-dimethylacetamide, and thereto 21.2 g (0.15 mole) of potassium carbonate and 27.1 g (0.14 mole ) of t-butyl bromoacetate were added. The resulting solution was stirred for 7 hours at 120°C. The reaction mixture thus obtained was poured into 1.5 liter of water, and then extracted with ethyl acetate. After drying with magnesium sulfate, the extract obtained was concentrated, and purified by column chromatography (carrier: silica gel, developing solvent: ethyl acetate/n-hexane (2/8 by volume) mixture). Thus, 24 g of light yellow powder was obtained. This light yellow powder was confirmed to be the following compound (all R groups were -CH₂-COO-C₄H₉(t)) by NMR measurement.

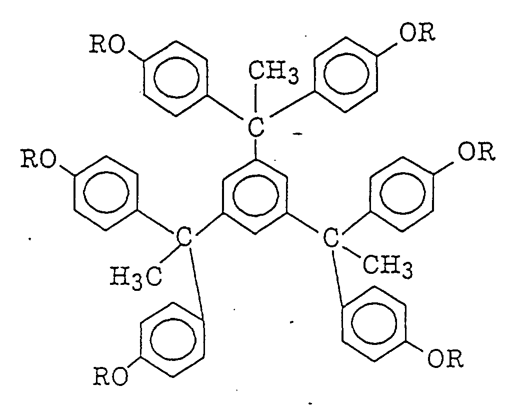

### Preparation and Evaluation of Photosensitive Compositions:

Each group of ingredients shown in Table 4 were dissolved in 6 g of diglime, and passed through a 0.2 µm filter to prepare each resist solution. This resist solution was coated on a silicon wafer by means of a spin coater revolving at 3,000 r.p.m., and dried for 60 seconds at 90°C on a hot plate of vacuum adsorption type, thereby forming a 1.0 µm-thick resist film.

The thus formed resist films were each exposed by means of a 248 nm KrF excimer laser stepper (NA= 0.45). After the exposure, each of the films was baked for 60 seconds with a 110°C hot plate of vacuum adsorption type, and at once dipped for 60 seconds in a water solution of tetramethylammonium hydroxide (TMAH) (the concentration of which is described below). Further, it was rinsed with water for 30 seconds, and then dried. The thus formed patterns on silicon wafers were observed under a scanning electron microscope, and thereby the resist profile was evaluated.

The evaluation results are shown in Table 5.

| | Developer used |
|---|---|
| Examples 13 to 18 | 2.38 % TMAH |
| Comparative Examples 7 and 8 | 2.38 % TMAH |
| Example 11 and 12 | 1.19 % TMAH |
| Comparative Examples 5 and 6 | 1.19 % TMAH |

The sensitivity was defined as the reciprocal of the exposure amount required for the reproduction of a 0.50 µm mask pattern, and the sensitivity values shown in Table 5 are relative values, with Comparative Example 1 being taken as 1.0.

The film shrinkage was expressed in terms of the percentage of the ratio between the film thicknesses in the exposed area before and after the post exposure bake.

The resolution was represented by the limiting resolution under the exposure amount required for the reproduction of a 0.50 µm mask pattern.

The resist profile was evaluated by the angle (θ) of a resist side wall formed with the silicon wafer plane in the cross section corresponding to a 0.50 µm mask pattern.

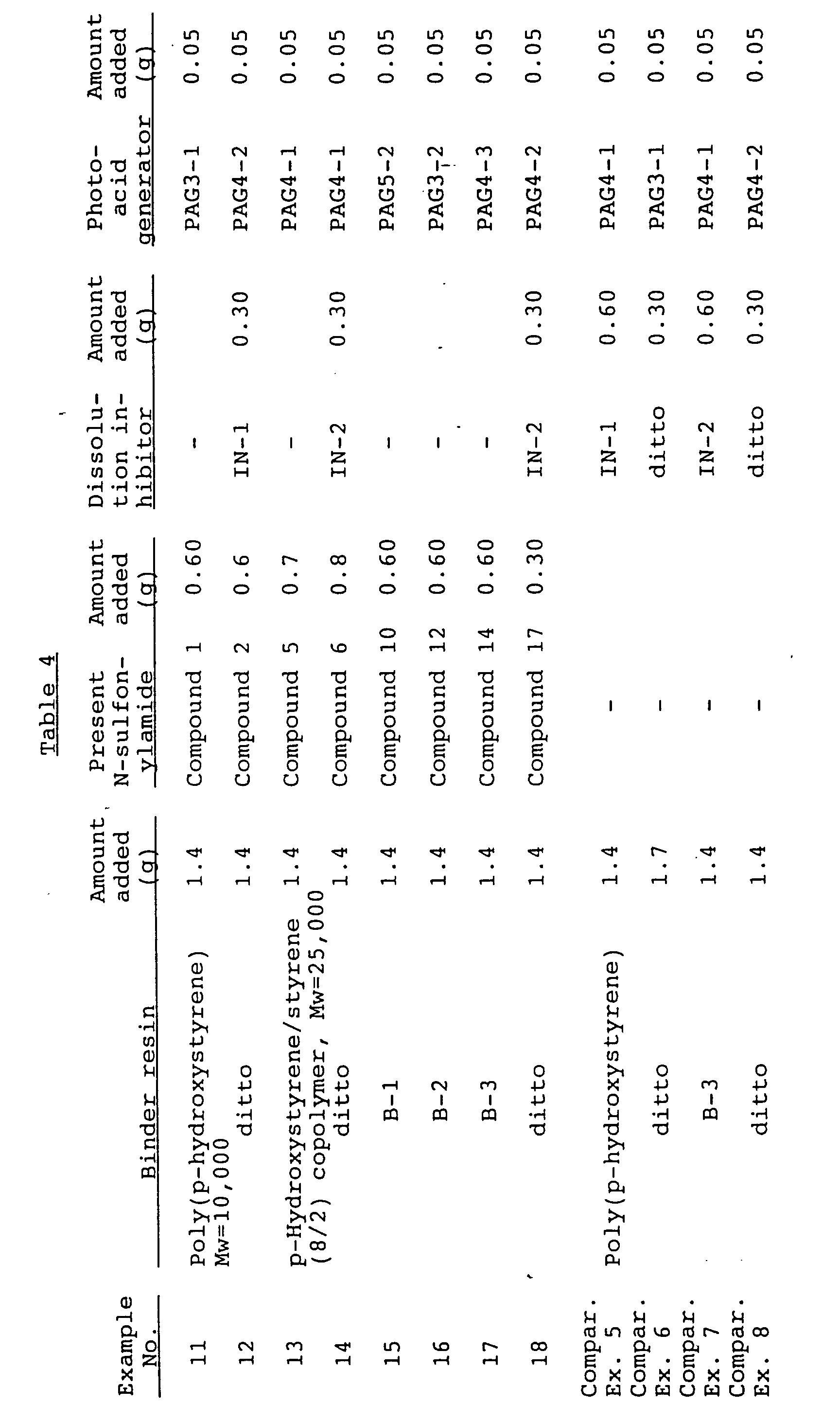

**Table 5**

| | Relative sensitivity | Film shrinkage | Resolution (µm) | Resist profile (θ) |
|---|---|---|---|---|
| Example 11 | 1.3 | 1 % | 0.27 [0.26] | 87° |
| Example 12 | 1.5 | 2 % | 0.27 [0.30] | 88° |
| Example 13 | 1.7 | 1 % | 0.25 [0.25] | 89° |
| Example 14 | 1.8 | 2 % | 0.26 [0.28] | 88° |
| Example 15 | 1.4 | 1 % | 0.24 [0.25] | 88° |
| Example 16 | 1.5 | 1 % | 0.24 [0.25] | 88° |
| Example 17 | 1.6 | 1 % | 0.25 [0.24] | 89° |
| Example 18 | 1.5 | 1 % | 0.26 [0.27] | 87° |
| Compar. Ex. 5 | 1.0 | 4 % | 0.31 [0.37] | 83° |
| Compar. Ex. 6 | 1.2 | 2 % | 0.33 [0.45] | 78° |
| Compar. Ex. 7 | 0.6 | 4 % | 0.30 [0.40] | 84° |
| Compar. Ex. 8 | 0.8 | 4 % | 0.32 [0.45] | 80° |
| Resolution (µm): The unparenthesized values are resolutions determined under a condition that the resist films were baked immediately after the exposure and then developed; while the values in the brackets are resolutions determined under a condition that the resist films were allowed to stand for 30 minutes after the exposure, baked and then developed. | | | | |

As can be seen from Table 5, the present resist films were less in film shrinkage due to post exposure baking and had better profile, higher sensitivity and higher resolutions than the comparative resist films. Further, the present resist films were almost free from the deterioration in resolution due to the time passing from the exposure till the heat treatment, indicating that they had excellent stability.

### EXAMPLES 19 AND 20

The surface of a 0.30 mm-thick aluminum plate was grained with a nylon brush and a water suspension of pumice powder of 400 mesh, and thoroughly washed with water. Then, the aluminum plate was etched by being dipped for 60 seconds in a 10 % sodium hydroxide solution kept at 70°C, followed by washing with running water. Further, the aluminum plate was washed with 20 % HNO₃ for neutralization, followed by washing with water. Furthermore, the electrolytic surface-roughening treatment of the aluminum plate was carried out in a 1 % water solution of nitric acid by furnishing anode electricity in a quantity of 160 coulomb/dm² using a sine-wave alternating waveform current under the condition of V_{A} = 12.7 V. The thus treated aluminum plate had the surface roughness of 0.6 µm expressed in terms of Ra). Subsequently, the aluminum plate was desmutted by being dipped for 2 minutes in a 30 % water solution of sulfuric acid kept at 55°C, and further anodically oxidized in a 20 % water solution of sulfuric acid under the electric current density of 2 A/dm² so as to have a thickness of 2.7 g/m².

On the thus prepared aluminum support, each of the following photosensitive solutions A and B was coated using a whirler at a rotating speed of 200 r.p.m., and dried for 1 minute at 100°C.

| Composition of Photosensitive Solution A (Example 19): | |
|---|---|
| N-Sulfonylamide polymer (P-4) of Synthesis Example B-1 | 5 g |
| 4-p-Tolylmercapto-2,5-diethoxybenzenediazonium hexafluorophosphate | 0.5 g |
| Dibutyltin laurate | 0.03 g |
| Diethylene glycol dimethyl ether | 40 g |
| Methyl ethyl ketone | 10 g |

| Composition of Photosensitive Solution B (Example 20): | |
|---|---|
| N-Sulfonylamide polymer (P-5) of Synthesis Example B-2 | 3.2 g |
| Phthalic acid anhydride | 5 mg |
| o-Chlorophenol | 1 mg |
| 4-p-Tolylmercapto-2,5-diethoxybenzenediazonium hexafluorophosphate | 0.3 g |
| Diethylene glycol dimethyl ether | 27 g |
| Methyl ethyl ketone | 10 g |

The presensitized plate having a coating of Photosensitive Solution B was further heated for 1 hour at 140°C.

Then, each plate was subjected to 500 count exposure by means of a printer, Ai Rotary Printer (made by Ai Graphics Co., Ltd.).

After the exposure, each plate was subjected to one-minute heat treatment and, without undergoing any development-processing, set in an offset printer, followed by printing operations.

Thus, 8,000 sheets of scum-free prints were obtained in the case of using the printing plate having a coating of Photosensitive Solution A; while 6,000 sheets of scum-free prints were obtained in the case of using the printing plate having a coating of Photosensitive Solution B.

### EXAMPLES 21 TO 25

A 100 µ-thick stainless plate was coated with a styrene-butadiene resin (1% toluene solution, Carton 1300 x, commercial name, a product of Shell Oil Company Ltd.), and heated at 170°C. To this support, the following photosensitive solution containing an N-sulfonylamide polymer was applied, dried for 1 minute at 100°C, and further heated for 1 hour at 140°C.

| | |
|---|---|
| N-Sulfonylamide polymer shown in Table 6 | 3.2 g |
| Phthalic anhydride | 5 mg |
| o-Chlorophenol | 1 mg |
| 2,6-Bis(trichloromethyl)-4-(4-methoxy-1-naphthyl) -s-triazine (Compound named PAG2-4 hereinbefore) | 0.3 g |
| Infrared absorbent NK-3508 (produced by Nippon Kanko Shikiso Kenkyusho K.K.) | 0.15 g |
| Dye (Victoria Pure Blue BOH having 1-naphthalene sulfonic acid ion as its counter ion) | 0.05 g |
| Megafac F-177 (fluorine-containing surfactant, produced by Dai-Nippon Ink & Chemicals, Inc.) | 0.06 g |
| Methyl ethyl ketone | 5 g |
| 1-Methoxy-2-propanol | 15 g |

The thus obtained lithographic plate materials were kept for 5 days under a high temperature-high humidity condition, specifically under the condition of 35°C-75 % RH. Then, they were each exposed by means of YAG laser emitting an infrared ray of 1064 nm. After the exposure, the plate materials underwent a one-minute heat treatment at 110°C and, without any development-processing, they were each subjected to printing operations with a press, Heidel KOR-D. The thus obtained prints were examined by visual observation as to whether or not scumming was generated on non-image areas. The observation results are shown in Table 6. The present plate materials gave well printed sheets free from scumming on non-image areas.

The number of printed sheets having no scumming are shown in Table 6.

**Table 1**

| Example | N-Sulfonylamide Polymer | Number of Printed Sheets |
|---|---|---|
| 3 | P - 1 | 30,000 |
| 4 | P - 2 | 42,000 |
| 5 | P - 3 | 55,000 |
| 6 | P - 7 | 40,000 |
| 7 | P - 8 | 45,000 |

### COMPARATIVE EXAMPLES 9 AND 10

In the same manner as in Examples 21 to 25, except that the following polymers were used respectively in place of the present N-sulfonylamide polymers, printing plates were produced, and then exposed, heated, set in the same press, Heidel KOR-D, without development-processing, and subjected to printing operations.

All the printed matters thus obtained had scumming in all areas, including image areas and non-image areas.

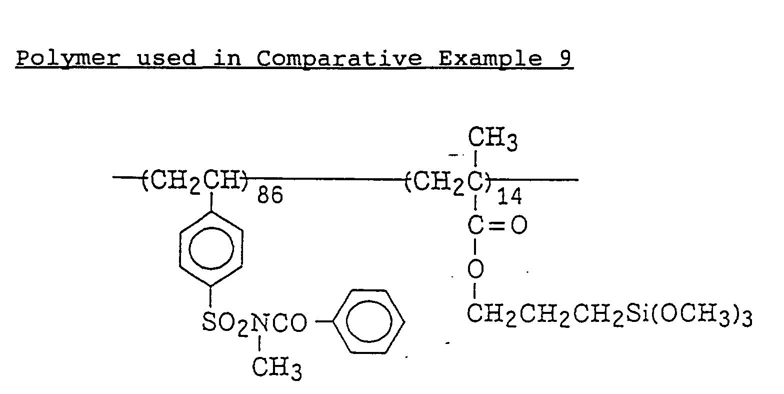

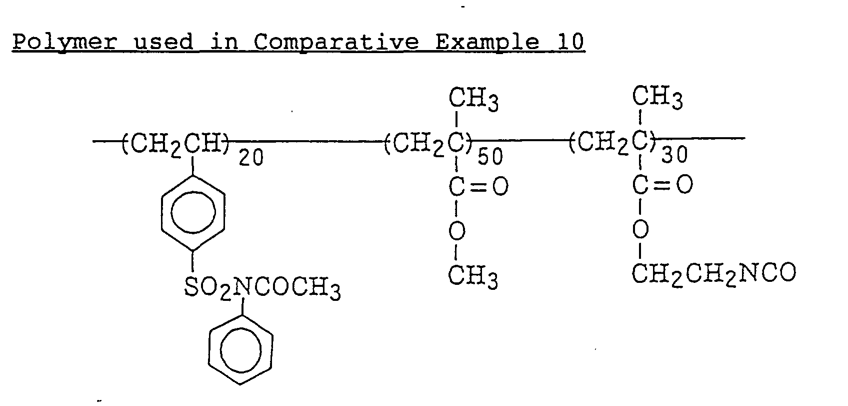

The figures in the foregoing structural formulae are mole fractions.

### EXAMPLES 26 TO 29 AND COMPARATIVE EXAMPLES 11 TO 13

On the same support as used in Example 19, the following photosensitive solution was coated and dried for 2 minutes at 100°C.

| | |
|---|---|
| N-Sulfonylamide polymer shown in Table 7 | 1.5 g |
| m/p-Cresol resin (m/p ratio: 6/4) | 3.0 g |
| 4-p-Tolylmercapto-2,5-diethoxybenzenediazonium hexafluorophosphate | 0.7 g |
| Crystal Violet | 0.01 g |
| Methyl ethyl ketone | 18 g |
| 1-Methoxy-2-propanol | 6 g |

The dry coverage of the photosensitive solution was 2.1 g/m². The thus obtained photosensitive lithographic printing plates were each exposed to light for 1 minute using a metal halide lamp via a step tablet, Fuji Step Guide (made by Fuji Photo Film Co., Ltd., having 15 steps, an initial-step optical transmission density of 0.05 and an increase of 0.15 in optical transmission density every one-step increase). Each of the exposed plates was developed by one-minute dip in a 4 % water solution of sodium metasilicate. The thus processed plate was examined by visual observation as to whether or not the photosensitive layer thereof was eluted in the exposed area to form an image (image formability). In addition, the sensitivity was evaluated by the number of steps present in the image formed. The greater number of steps in an image obtained is an indication of the higher sensitivity. The results obtained are shown in Table 7. It can be seen from the results shown in Table 7 that the combinations of the present acid-decomposable polymers with a novolak resin afforded excellent image formability and high sensitivity.

**Table 7**

| | N-sulfonylamide Polymer | Image Formability | Sensitivity |
|---|---|---|---|
| Example 26 | P - 8 | clear image | 6 |
| Example 27 | P - 9 | clear image | 8 |
| Example 28 | P - 13 | clear image | 7 |
| Example 29 | P - 14 | clear image | 8 |
| Comparative Example 11 | absent | no image (dissolved completely) | - |
| Comparative Example 12* | absent | clear image | 5 |
| Comparative Example 13 | N-sulfonylamide polymer shown below | no image | - |

| | | | |
|---|---|---|---|
| ( * : Standard positive working printing plate, VPS (produced by Fuji Photo Film Co., Ltd.), was used. ) | | | |

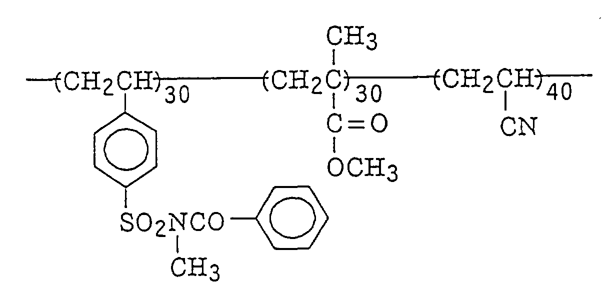

The results obtained in Examples 19 to 25 demonstrate that the production of original plates without requiring development-processing has been effected by using the photosensitive compositions comprising polymers having N-sulfonylamido groups according to the present invention.

On the other hand, the results obtained in Examples 26 to 29 show that the original plates having high sensitivity and excellent image formability have been prepared by using the photosensitive compositions comprising polymers having N-sulfonylamido groups according to the present invention, and further by performing conventional development-processing.

The positive image forming compositions according to the present invention can provide resist compositions which ensure high sensitivities and a reduction in film shrinkage due to post exposure baking, satisfactory profile and high resolution, and hardly suffer deterioration in resolution due to the time passing from the exposure to the heat treatment because of their excellent stability. Further, the present compositions can provide offset printing plates having high sensitivities to light of wavelengths covering from UV region to infrared region and generating no scum in non-image areas.

In accordance with the present invention, a lithographic plate capable of proving scum-free printed matters is produced without performing development-processing after exposure. Further, the present invention can provide a printing plate having high sensitivities to light of longer wavelengths, particularly to visible light and infrared laser beams, high stability upon storage, and no scum in non-image areas.

## Claims

1. A positive image forming composition comprising (a) a compound generating an acid by undergoing the action of light or heat and (b) at least one compound selected from the N-sulfonylamide compounds represented by the following formula (I) or (II):
L₁ - (SO₂ - NR₂ - CO - R₁)ₙ (I)
L₁ - (CO - NR₂ - SO₂ - R₁)ₙ (II)
wherein n is an integer of from 1 to 6; R₁ represents an aromatic group or an alkyl group; L₁ represents an aromatic group or an alkyl group when n is 1, or L₁ represents a polyvalent linkage group constituted of nonmetal atoms when n is from 2 to 6; and R₂ represents a tertiary alkyl group, an alkoxymethyl group, an arylmethyl group or an alicyclic alkyl group.

2. A positive image forming composition according to claim 1, wherein the N-sulfonylamide compound of formula (I) or (II) contains as R₂ a t-butyl group or a 2,2-dimethyl-4,4-dimethylbutyl group.

3. A positive image forming composition according to claim 1, wherein the N-sulfonylamide compound of formula (I) or (II) contains as R₂ a benzyloxymethyl group, a methoxymethyl group, a 1-ethoxyethyl group, a methoxyethoxymethyl group, a tetrahydropyranyl group or a tetrahydrofuranyl group.

4. A positive image forming composition according to claim 1, wherein the N-sulfonylamide compound of formula (I) or (II) contains as R₂ a p-methoxybenzyl group, a 2,4,6-trimethoxybenzyl group, a piperonyl group or a 9-anthranylmethyl group.

5. A positive image forming composition according to claim 1, wherein the N-sulfonylamide compound of formula (I) or (II) contains as R₂ a cyclohexyl group or a dibenzosuberyl group.

6. A positive image forming composition according to any one of claims 1 to 5, wherein the acid generating compound (a) is at least one compound selected from the group consisting of oxadiazole compounds having trihalomethyl substituents, s-triazine compounds having trihalomethyl substituents, iodonium salts, sulfonium salts, diazonium salts, disulfone compounds and iminosulfonate compounds.

7. A positive image forming composition according to any one of claims 1 to 6, further comprising (c) a high molecular organic binder which is insoluble in water but soluble or at least swellable in an aqueous alkaline solution.

8. A positive image forming composition comprising (a) a compound generating an acid by undergoing the action of light or heat and (c) a polymer having constitutional units represented by the following formula (III):
- SO₂ - NR₃ - CO - (III)
wherein R₃ represents a tertiary alkyl group, an alkoxymethyl group, an arylmethyl group or an alicyclic alkyl group.

## Patentansprüche

1. Positiv arbeitende, bilderzeugende Zusammensetzung, umfassend (a) eine Verbindung, die eine Säure durch Einwirkung von Licht oder Wärme erzeugt, und (b) mindestens eine Verbindung, ausgewählt aus den durch die folgenden Formeln (I) oder (II) dargestellten N-Suifonylamid-Verbindungen:
L₁-(SO₂-NR₂-CO-R₁)ₙ (I)
L₁-(CO-NR₂-SO₂-R₁)ₙ (II)
worin n eine ganze Zahl von 1 bis 6 ist, R₁ eine aromatische Gruppe oder eine Alkylgruppe ist, L₁ eine aromatische Gruppe oder eine Alkylgruppe darstellt, wenn n 1 ist, oder L₁ eine mehrwertige Verknüpfungsgruppe, die von Nicht-metallatomen gebildet ist, darstellt, wenn n 2 bis 6 ist, und R₂ eine tertiäre Alkylgruppe, eine Alkoxymethylgruppe, eine Arylmethylgruppe oder eine alicyclische Alkylgruppe darstellt.

2. Positiv arbeitende, bilderzeugende Zusammensetzung nach Anspruch 1, worin die N-Sulfonylamid-Verbindung der Formel (I) oder (II) als R₂ eine tert.-Butylgruppe oder eine 2,2-Dimethyl-4,4-dimethylbutylgruppe enthält.

3. Positiv arbeitende, bilderzeugende Zusammensetzung nach Anspruch 1, worin die N-Sulfonylamid-Verbindung der Formel (I) oder (II) als R₂ eine Benzyloxymethylgruppe, eine Methoxymethylgruppe, eine 1-Ethoxyethyl-gruppe, eine Methoxyethoxymethylgruppe, eine Tetrahydropyranylgruppe oder eine Tetrahydrofuranylgruppe enthält.

4. Positiv arbeitende, bilderzeugende Zusammensetzung nach Anspruch 1, worin die N-Suifonylamid-Verbindung der Formel (I) oder (II) als R₂ eine p-Methoxybenzylgruppe, eine 2,4,6-Trimethoxybenzylgruppe, eine Piperonyl-gruppe oder eine 9-Anthranylmethylgruppe enthält.

5. Positiv arbeitende, bilderzeugende Zusammensetzung nach Anspruch 1, worin die N-Sulfonylamid-Verbindung der Formel (I) oder (II) als R₂ eine Cyclohexylgruppe oder eine Dibenzosuberylgruppe enthält.

6. Positiv arbeitende, bilderzeugende Zusammensetzung nach irgendeinem der Ansprüche 1 bis 5, worin die Säure-bildende Verbindung (a) mindestens eine Verbindung ausgewählt aus der Gruppe bestehend aus Oxadiazol-Verbindun-gen mit Trihalogenmethyl-Substituenten, s-Triazin-Verbindungen mit Trihalo-genmethyl-Substituenten, lodoniumsalzen, Sulfoniumsalzen, Diazonium-salzen, Disulfon-Verbindungen und lminosulfonat-Verbindungen ist.

7. Positiv arbeitende, bilderzeugende Zusammensetzung nach irgendeinem der Ansprüche 1 bis 6, die ferner (c) ein hochmolekulares organisches Bindemittel umfaßt, das in Wasser unlöslich, aber in einer wäßrigen alkalischen Lösung löslich oder zumindest quellbar ist.

8. Positiv arbeitende, bilderzeugende Zusammensetzung, umfassend (a) eine Verbindung, die eine Säure durch Einwirkung von Licht oder Wärme erzeugt, und (c) ein Polymer mit den durch die folgende Formel (III) dargestellten Struktureinheiten:
- SO₂ - NR₃ - CO - (III)
worin R₃ eine tertiäre Alkylgruppe, eine Alkoxymethylgruppe, eine Arylmethyl-gruppe oder eine alicyclische Alkylgruppe darstellt.

## Revendications

1. Composition de formation d'image de type positif comprenant
(a) un composé produisant un acide lorsqu'il subit l'action de la lumière ou de la chaleur et (b) au moins un composé sélectionné parmi les composés N-sulfonylamides représentés par les formules suivantes (I) ou (II):
L₁ - (SO₂ - NR₂ - CO - R₁)ₙ (I)
L₁ - (CO - NR₂ - SO₂ - R₁)ₙ (II)
dans lesquelles n est un entier de 1 à 6; R₁ représente un groupe aromatique ou un groupe alkyle; L₁ représente un groupe aromatique ou un groupe alkyle lorsque n vaut 1, ou L₁ représente un groupe de liaison polyvalent constitué d'atomes non métalliques lorsque n vaut de 2 à 6; et R₂ représente un goupe alkyle tertiaire, un groupe alkoxyméthyle, un groupe arylméthyle ou un groupe alkyle alicyclique.

2. Composition de formation d'image de type positif selon la revendication 1, dans laquelle le composé N-sulfonylamide de la formule (I) ou (II) contient en tant que R₂ un groupe t-butyle ou un groupe 2,2-diméthyl-4,4-diméthylbutyle.

3. Composition de formation d'image de type positif selon la revendication 1 dans laquelle le composé N-sulfonylamide de la formule (I) ou (II) contient en tant que R₂ un groupe benzyloxyméthyle, un groupe méthoxyméthyle, un groupe 1-éthoxyéthyle, un groupe méthoxyéthoxyméthyle, un groupe tétrahydropyranyle ou un groupe tétrahydrofuranyle.

4. Composition de formation d'image de type positif selon la revendication 1, dans laquelle le composé N-sulfonylamide de la formule (I) ou (II) contient en tant que R₂ un groupe p-méthoxybenzyle, un groupe 2,4,6-triméthoxybenzyle, un groupe pipéronyle, ou un groupe 9-anthranylméthyle.

5. Composition de formation d'image de type positif selon la revendication 1, dans laquelle le composé N-sulfonylamide de la formule (I) ou (II) contient en tant que R₂ un groupe cyclohexyle ou un groupe dibenzosubéryle.

6. Composition de formation d'image de type positif selon l'une quelconque des revendications 1 à 5, dans laquelle le composé (a) produisant un acide est au moins un composé choisi dans le groupe consistant en des composés oxadiazole présentant des substituants trihalométhyle, des composés s-triazine présentant des substituants trihalométhyle, des sels iodonium, des sels sulfonium, des sels diazonium, des composés disulfone et des composés iminosulfonate.

7. Composition de formation d'image de type positif selon l'une quelconque des revendications 1 à 6, comprenant de plus (c) un liant organique à haut poids moléculaire (c) qui est insoluble dans l'eau mais soluble ou au moins susceptible de foisonner dans une solution alcaline aqueuse.

8. Composition de formation d'image de type positif comprenant (a) un composé produisant un acide lorsqu'il subit l'action de la lumière ou de la chaleur et (c) un polymère présentant des unités constitutives représentées par la formule(III) suivante:
- SO₂ - NR₃ - CO - (III)
dans laquelle R₃ représente un groupe alkyle tertiaire, un groupe alkoxyméthyle, un groupe arylméthyle ou un groupe alkyle alicyclique.
